(19) Europäisches Patentamt
European Patent Office
Office européen des brevets

(11) **EP 4 656 646 A1**

(12) **EUROPEAN PATENT APPLICATION**
published in accordance with Art. 153(4) EPC

(43) Date of publication:
**03.12.2025 Bulletin 2025/49**

(21) Application number: **24747463.8**

(22) Date of filing: **25.01.2024**

(51) International Patent Classification (IPC):
***C07F 15/00*** *(2006.01)* ***H10K 85/30*** *(2023.01)*
***H10K 50/12*** *(2023.01)* ***C09K 11/06*** *(2006.01)*
***H10K 101/20*** *(2023.01)*

(52) Cooperative Patent Classification (CPC):
**C07F 15/00; C09K 11/06; H10K 50/12; H10K 85/30;** H10K 2101/20

(86) International application number:
**PCT/KR2024/001207**

(87) International publication number:
**WO 2024/158229 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.01.2023 KR 20230009686**

(71) Applicant: **Lordin Co., Ltd**
**Hwaseong-si, Gyeonggi-do 18469 (KR)**

(72) Inventors:
- **PARK, Bu Bae**
  **Hwaseong-si Gyeonggi-do 18469 (KR)**
- **HAN, Ga Ram**
  **Osan-si Gyeonggi-do 18113 (KR)**
- **KIM, Eun Bi**
  **Hwaseong-si Gyeonggi-do 18479 (KR)**

(74) Representative: **Pfenning, Meinig & Partner mbB**
**Patent- und Rechtsanwälte**
**Theresienhöhe 11a**
**80339 München (DE)**

# (54) NOVEL MULTIFUNCTIONAL COMPOUND AND ORGANIC LIGHT-EMITTING DIODE COMPRISING SAME

(57) The present invention relates to a novel multifunctional compound and an organic light-emitting diode including the same. More specifically, the present invention relates to an organic light-emitting diode wherein a novel multifunctional compound capable of efficiently transferring energy is employed, thereby improving quantum efficiency.

【FIG. 2】

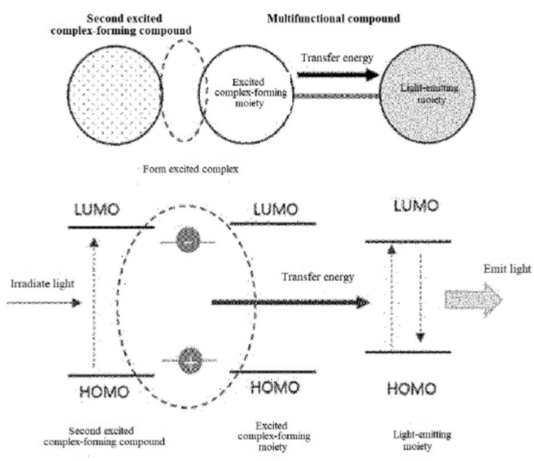




EP 4 656 646 A1

## Description

### Technical Field

The present invention relates to a novel multifunctional compound and an organic light-emitting diode including the same. More specifically, the present invention relates to an organic light-emitting diode wherein a novel multifunctional compound capable of efficiently transferring energy is employed, thereby improving quantum efficiency.

### Background Art

An organic light-emitting diode (OLED) is a device in which holes injected from an anode and electrons injected from a cathode combine in a light-emitting layer to form excitons and emit light, and was first reported in Appl. Phys. Lett 51, 913 by C. W. Tang in 1987. Two electrons having different spins are present in the HOMO wave function of a light-emitting layer host. A phenomenon of electrons directly leaving from and entering into an organic material occurs in an OLED in which the electrons leave at a HOMO (Highest Occupied Molecular Orbital) level and are injected at a LUMO (Lowest Unoccupied Molecular Orbital) level. Herein, since the spin directions of the leaving or entering electrons are not determined, the formed excitons are a triplet in the same direction and a singlet in a different spin direction. In an organic material, a triplet normally has smaller energy by 0.5 eV to 1 eV due to exchange energy and repulsive energy between electrons. The ratio between a singlet and a triplet is theoretically 25% and 75%, and the singlet is emitted as light, but the triplet is lost as heat. In order to increase internal quantum efficiency of an OLED device, the triplet needs to be induced to be emitted as light. Mark E. Thompson reported a technique of emitting a triplet as light by increasing spin-orbit coupling using a heavy metal such as Pt in the patent (US6303238B1) filed in 1997. Chihaya Adachi designed a molecule to have a minimum wave function overlap between HOMO and LUMO in one molecule, which was reported in Nature, 2012, 492, 234-238. In this way, the designed molecule increases efficiency due to thermally activated delayed fluorescence (TADF) in which energy of the triplet is transferred to the singlet to emit light. However, the method of using a heavy metal requires very expensive metals such as Pt and Ir, and may have a problem in material stability due to high HOMO-LUMO gap energy of the singlet since a blue color needs to be expressed in the triplet. The method of using thermally activated delayed fluorescence has a problem in that it is difficult to implement a deep blue color since full width at half maximum (FWHM) of the emission spectrum is widened due to a small degree of overlap between the wave functions of HOMO and LUMO, and there is also a problem in material stability.

Another method that has been studied to reduce the energy difference between a singlet and a triplet is to form an excited complex between a relatively electron-rich electron donor molecule and an electron-deficient electron acceptor molecule, and when an electron donor (or electron acceptor) molecule absorbs light and becomes excited, the excited molecule and an electron acceptor (or electron donor) molecule in a ground state form an excited complex (exciplex) by Coulombic interaction (Valeur, B, Berberan-santos, M.N, Wiley-VCH Verlag GmbH & co. KGaA, 2nd edition, 2012). In this state, light emission efficiency may be increased since a difference between the triplet energy and the singlet energy is small. However, even when forming such an excited complex, there is a problem in that it is difficult to obtain a deep blue color by having a very wide emission spectrum FWHM, and when doping a dopant to obtain a deep blue color, energy transfer from the excited complex to the dopant is not efficient, causing a problem of not obtaining high quantum efficiency.

## DISCLOSURE

### Technical Problem

An object of the present invention is to provide a novel multifunctional compound capable of efficiently transferring energy.

Another object of the present invention is to provide an organic light-emitting diode having improved quantum efficiency through efficiently transferring energy by the multifunctional compound.

Objects of the present invention are not limited to the object mentioned above, and other objects and advantages of the present invention not mentioned herein may be understood by the following description, and will be more clearly understood by embodiments of the present invention. In addition, it may be readily seen that objects and advantages of the present invention may be embodied by means described in the claims and combinations thereof.

### Technical Solution

One embodiment of the present invention provides a multifunctional compound represented by the following Chemical Formula 1.

<Chemical Formula 1>

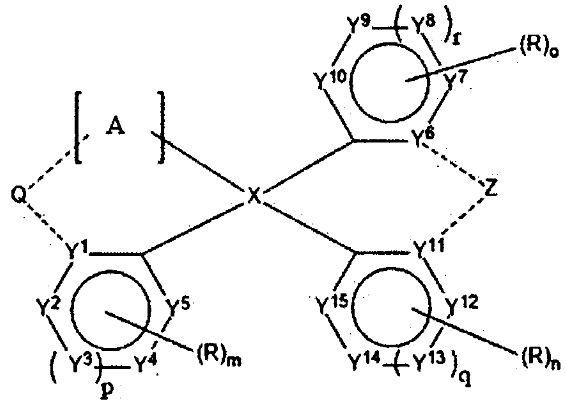

In Chemical Formula 1,

A is a structure represented by the following Chemical Formula 2, and is linked through a first linking position of A, or linked through a first linking position and a second linking position of A,

X is C, Si, Ge, Sn or Pb, and the first linking position of A is linked to X,

Q is not present, or a single bond, $-B(Ar^1)-$, $-C(Ar^1)(Ar^2)-$, $-Si(Ar^1)(Ar^2)-$, $-Ge(Ar^1)(Ar^2)-$, $-N(Ar^1)-$, $-P(Ar^1)-$, $-PO(Ar^1)-$, -O-, -S-, -SO-, $-SO_2-$, -Se-, -SeO-, $-SeO_2-$, -CO-, -CS- or -CSe-, and herein, $Ar^1$ and $Ar^2$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^1$ and $Ar^2$ may be linked to each other to form a ring, or may each be linked to $Y^2$, R that is linked to $Y^2$, or A to form a fused ring,

when Q is not present, A is not directly linked to $Y^1$ at the second linking position of A,

when Q is a single bond, A is linked to $Y^1$ by a single bond at the second linking position of A,

when Q is not a single bond and is present as any one defined as above, A is linked to Q at the second linking position of A,

when Q is not a single bond and is present as any one defined as above, Q is linked to A and $Y^1$ each by a single bond,

$Y^1$ to $Y^{15}$ are each independently boron, carbon, nitrogen, oxygen, sulfur, Se or Te,

Z is not present, or a single bond, $-B(Ar^3)-$, $-C(Ar^3)(Ar^4)-$ $-Si(Ar^3)(Ar^4)-$, $-Ge(Ar^3)(Ar^4)-$, $-N(Ar^3)-$, $-P(Ar^4)-$, $-PO(Ar^3)-$, -O-, -S-, -SO-, $-SO_2-$, -Se-, -SeO-, $-SeO_2-$, -CO-, -CS- or -CSe-, and herein, $Ar^3$ and $Ar^4$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^3$ and $Ar^4$ may be linked to each other to form a ring, or may each be linked to any one of $Y^7$, $Y^{12}$, R that is linked to $Y^7$ or R that is linked to $Y^{12}$ to form a fused ring,

when Z is not present, $Y^6$ and $Y^{11}$ are not directly linked,

when Z is a single bond, $Y^6$ and $Y^{11}$ are linked by a single bond,

when Z is not a single bond and is present as any one defined as above, Z is linked to $Y^6$ and $Y^{11}$ each by a single bond,

m, n and o are each independently an integer of 0 to 5,

Rs are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with

an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent,

allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, -B($R^{101}$)($R^{102}$), -C($R^{103}$)($R^{104}$)($R^{105}$), - Si($R^{106}$)($R^{107}$)($R^{108}$), -Ge ($R^{109}$) ($R^{110}$) ($R^{111}$), -N($R^{112}$)($R^{113}$), - P($R^{114}$)($R^{115}$), -PO($R^{116}$)($R^{117}$), -O($R^{118}$), -S($R^{119}$), -SO($R^{120}$), - $SO_2$($R^{121}$), Se($R^{122}$), -SeO($R^{123}$), -$SeO_2$($R^{124}$) and combinations thereof,

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom may be linked to form a ring,

at least two Rs present when m, n or o is 2 or greater may be linked to each other to form a ring,

p, q and r each independently represent 0 or 1, and when p, q or r is 0, it means that a 5-membered ring is formed, and when p, q or r is 1, it means that a 6-membered ring is formed,

however, at least one atom of $Y^6$ to $Y^{15}$ and Z is an atom including an unshared electron pair, or R bonding thereto includes at least one atom including an unshared electron pair,

<Chemical Formula 2>

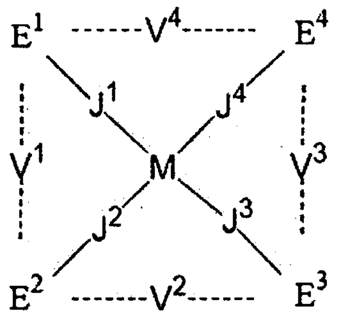

in Chemical Formula 2,

M is a transition metal,

$V^1$, $V^2$, $V^3$ and $V^4$ are each independently not present, or a single bond, -B($Ar^5$)-, -C($Ar^5$) ($Ar^6$)-, -Si($Ar^5$)($Ar^6$)-, - Ge($Ar^5$) ($Ar^6$)-, -N($Ar^5$)-, -P($Ar^5$)-, -PO($Ar^5$)-, -O-, -S-, -SO-, -$SO_2$-, -Se-, -SeO-, -$SeO_2$-, -CO-, -CS- or -CSe-, and herein, $Ar^5$ and $Ar^6$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^5$ and $Ar^6$ may be linked to each other to form a ring, or may each be linked to adjacent $E^1$, $E^2$, $E^3$ or $E^4$ to form a fused ring,

however, at least one of $V^1$, $V^2$, $V^3$ and $V^4$ is a single bond,

when $V^1$, $V^2$, $V^3$ and $V^4$ are not present, two of the adjacent $E^1$, $E^2$, $E^3$ and $E^4$ adjacent thereto are not directly linked, when $V^1$, $V^2$, $V^3$ and $V^4$ are a single bond, two of the adjacent $E^1$, $E^2$, $E^3$ and $E^4$ are directly linked by a single bond, and when $V^1$, $V^2$, $V^3$ and $V^4$ are not a single bond and are present as any one defined as above, they are linked to two of the adjacent $E^1$, $E^2$, $E^3$ and $E^4$ each by a single bond, or two bonds linked to two of the adjacent $E^1$, $E^2$, $E^3$ and $E^4$ may form

a conjugated structure together,

$J^1$, $J^2$, $J^3$ and $J^4$ are each a single bond, O or S,

when $J^1$, $J^2$, $J^3$ and $J^4$ are a single bond, any one of $E^1$, $E^2$, $E^3$ and $E^4$ linked thereto directly bonds to M by a coordination bond or a covalent bond,

when $J^1$, $J^2$, $J^3$ and $J^4$ are O or S, the bond with M is a coordination bond or a covalent bond,

$E^1$, $E^2$, $E^3$ and $E^4$ are each independently a monovalent, divalent or trivalent group and defined as below, provided that, when $E^1$, $E^2$, $E^3$ and $E^4$ are a monovalent group, the adjacent two of $V^1$, $V^2$, $V^3$ and $V^4$ are both absent; when $E^1$, $E^2$, $E^3$ and $E^4$ are a divalent group, any one of the adjacent two of $V^1$, $V^2$, $V^3$ and $V^4$ is not present; and when $E^1$, $E^2$, $E^3$ and $E^4$ are a trivalent group, the adjacent two of $V^1$, $V^2$, $V^3$ and $V^4$ are both present,

$E^1$, $E^2$, $E^3$ and $E^4$ are each independently a monovalent group of halogen or cyano, or saturated or unsaturated aliphatic hydrocarbon having 1 to 50 carbon atoms unsubstituted or substituted with an additional substituent; saturated or unsaturated heteroatom-containing aliphatic hydrocarbon having 1 to 50 carbon atoms unsubstituted or substituted with an additional substituent; an aromatic carbon ring having 5 to 50 carbon atoms unsubstituted or substituted with an additional substituent; an aromatic heteroring having 2 to 50 carbon atoms unsubstituted or substituted with an additional substituent; a saturated or unsaturated alicyclic carbon ring having 3 to 50 carbon atoms unsubstituted or substituted with an additional substituent; or a saturated or unsaturated alicyclic heteroring having 2 to 50 carbon atoms unsubstituted or substituted with an additional substituent,

at least two additional substituents included in $E^1$, $E^2$, $E^3$ and $E^4$ may be linked to form a ring,

however, when $J^1$, $J^2$, $J^3$ or $J^4$ is a single bond, the atom at the linking position from the adjacent $E^1$, $E^2$, $E^3$ or $E^4$ to M is carbon, nitrogen, oxygen, sulfur or phosphorous; or when $J^1$, $J^2$, $J^3$ or $J^4$ is O or S, the atom at the linking position from the adjacent $E^1$, $E^2$, $E^3$ or $E^4$ to O or S of $J^1$, $J^2$, $J^3$ or $J^4$ is carbon,

in any one of $E^1$, $E^2$, $E^3$ and $E^4$, the linking position to the adjacent $J^1$, $J^2$, $J^3$ or $J^4$ and the linking position to the adjacent $V^1$, $V^2$, $V^3$ or $V^4$ are adjacent to each other,

in any one of $E^1$, $E^2$, $E^3$ and $E^4$, the linking positions to two of the adjacent $V^1$, $V^2$, $V^3$ and $V^4$ are different from each other,

an atom capable of bonding according to a stoichiometric ratio except for M in Chemical Formula 2 may be the first linking position or the second linking position of A in Chemical Formula 1, provided that, the first linking position and the second linking position are each (i) different from the linking position from any one of $E^1$, $E^2$, $E^3$ and $E^4$ to the adjacent $J^1$, $J^2$, $J^3$, $J^4$, $V^1$, $V^2$, $V^3$ or $V^4$, and (ii) different from the linking position from any one of $V^1$, $V^2$, $V^3$ and $V^4$ to the adjacent $E^1$, $E^2$, $E^3$ or $E^4$,

the first linking position and the second linking position are adjacent to each other, and

the additional substituents may be present in the numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$ , $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{220})$, $-SO_2(R^{221})$, $Se(R^{222})$ $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms.

Another embodiment of the present invention provides an organic light-emitting diode including: a first electrode; a second electrode; and a light-emitting layer disposed between the first electrode and the second electrode; and further including or not including an organic layer adjacent to any one or both surfaces of the light-emitting layer, wherein the light-emitting layer includes the multifunctional compound, and the light-emitting layer or the adjacent organic layer includes an excited complex-forming compound.

## Advantageous Effects

The multifunctional compound enables an effective energy transfer between moieties in the multifunctional compound while reducing an energy difference between a singlet and a triplet, readily implements various colors including a deep blue color and achieves an efficient energy transfer, and therefore, an organic light-emitting diode using the multifunctional compound is able to have high quantum efficiency.

Specific effects of the present invention in addition to the above-described effect will be described together while

describing specific details to carry out the present invention hereinafter.

## Brief Description of Drawings

FIG. 1 is a diagram illustrating a working mechanism of a multifunctional compound according to one embodiment of the present invention hereinafter.

FIG. 2 schematically illustrates a mechanism in which excited energy of an excited complex is transferred between moieties in the multifunctional compound and light is emitted in an organic light-emitting diode according to one embodiment of the present invention.

FIG. 3 is a graph comparing device properties of Example 1 and Comparative Example 1.

## Best Mode

Hereinafter, embodiments of the present invention will be described in detail with reference to drawings so that those skilled in the art may readily carry out the present invention. The present invention may be embodied in various different forms, and is not limited to the embodiments described herein.

In the present specification, the term "substitution" means that a hydrogen atom bonding to a carbon atom in a compound is substituted with another substituent. The position where substitution occurs means a position at which the hydrogen atom is substituted. The position is not limited as long as it is a position where hydrogen at the position may be substituted with a substituent. When two or more substitutions occur, the two or more substituents may be the same as or different from each other.

In the present specification, the substituent when "substituted" may be, unless otherwise stated, selected from the group consisting of, for example, deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$ , $Si(R^{206})(R^{207})(R^{208})$, $-Ge(R^{209})(R^{210})(R^{211})$, $-N(R^{212})(R^{213})$, $- P(R^{214}) (R^{215})$, $-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ may be each independently one selected from the group consisting of hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, heteroaryl having 2 to 30 carbon atoms and combinations thereof, but are not limited thereto.

"Combinations thereof" in the definition of substituents of the present specification means that, unless otherwise defined, two or more substituents are present, or two or more divalent substituents are linked or fused for bonding.

In the present specification, a case of two substituents being linked to form a ring includes a case in which one of the two substituents is hydrogen, and the two substituents are linked as the hydrogen is removed.

In the present specification, unless otherwise stated, "alkyl" includes linear or branched forms, and, unless otherwise stated, is a collective name that includes "cycloalkyl and heterocycloalkyl". In the present specification, unless otherwise stated, "alkenyl" includes linear or branched forms, and, unless otherwise stated, is a collective name that includes "cycloalkenyl and heterocycloalkenyl". For example, unless otherwise stated, alkylamine is a collective name that includes cycloalkylamine and heterocycloalkylamine.

In the present specification, "heteroalkyl" or "heteroalkylene" refers to a case in which at least one carbon atom in alkyl or alkylene is substituted with a heteroatom, and the number of carbon atoms thereof means the number of carbon atoms excluding the heteroatom.

In the present specification, "heteroalkenyl" refers to a case in which at least one carbon atom that does not form a double bond in alkenyl is substituted with a heteroatom, and the number of carbon atoms thereof means the number of carbon atoms excluding the heteroatom.

In the present specification, "heterocycloalkyl" refers to a case in which at least one carbon atom in cycloalkyl is substituted with a heteroatom, and the number of carbon atoms thereof means the number of carbon atoms excluding the heteroatom.

In the present specification, "heterocycloalkenyl" refers to a case in which at least one carbon atom that does not form a double bond in cycloalkenyl is substituted with a heteroatom, and the number of carbon atoms thereof means the number of carbon atoms excluding the heteroatom.

In the present specification, "hetero" means, unless otherwise defined, including a heteroatom in one compound

or substituent. The heteroatom means an atom that is not carbon and hydrogen. Examples thereof may include N, O, Si, Ge, S, P, B, Se, Te and the like, but are not limited thereto. When two or more heteroatoms are included in one compound or substituent, the included heteroatoms may be the same as or different from each other, and, for example, be one, or two or more types of heteroatoms. For example, heteroaryl or heterocycloalkyl includes at least one heteroatom as an atom forming the ring.

In the present specification, "aryl", "arylene" or "aromatic" may be a monocyclic ring or a polycyclic ring according to a commonly known definition, and includes a conjugated structure in a part or all thereof. The polycyclic ring may be a fused ring or a linked form, and for example, aryl or aromatic carbon ring includes biphenyl.

Substituents other than the substituents defined as above as substituents mentioned in the present specification follow known definitions of substituents.

In the present specification, when substituents or linking positions are adjacent in chemical formulae, it means a case in which atoms to which the substituents are linked or atoms of the linking positions are directly linked.

In the present specification, when a definition of a substituent includes a case of being substituted with an additional substituent, the additional substituent belongs to the category of the defined substituent, unless otherwise stated. For example, when Z of Chemical Formula 1 is -N($Ar^1$)-and $Ar^1$ is phenyl substituted with methyl as an additional substituent, methyl as the additional substituent belongs to Z. In other words, the category of Z herein includes methyl that is an additional substituent. Z is described as an example herein, however, for all substituents defined in chemical formulae in the present specification, it needs to be understood that, when it is possible to be substituted with an additional substituent, the additional substituent is included in the category of the defined substituent. As another example, the first linking position or the second linking position of A in Chemical Formula 1 may be positioned at an additional substituent defined to be within the category of A, and similarly, the linking position of $E^1$ or the like in Chemical Formula 2 may be positioned at an additional substituent that belongs to the category of $E^1$.

In the present specification, the number of substitutions with additional substituents may be the number capable of bonding according to a stoichiometric ratio unless otherwise stated.

In the present specification, a ring includes a fused ring unless otherwise stated.

In the present specification, when two entities (substituents and the like) are linked, it includes a case in which any one of the entities is hydrogen, and the entities are linked as the hydrogen is eliminated.

In the present specification, unless otherwise stated, a dotted line in a chemical structural formula represents that it may or may not be present.

In the present specification, both a coordination bond and a single bond in a chemical structural formula are expressed as a straight line and not distinguished, however, all structures capable of bonding according to a stoichiometric ratio are included.

One embodiment of the present invention provides,

a multifunctional compound represented by the following Chemical Formula 1.

<Chemical Formula 1>

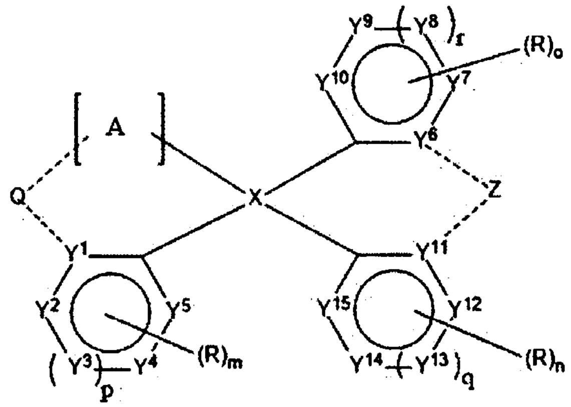

In Chemical Formula 1,

A is a structure represented by the following Chemical Formula 2, and is linked through a first linking position of A, or linked through a first linking position and a second linking position of A,

X is C, Si, Ge, Sn or Pb, and the first linking position of A is linked to X,

Q is not present, or a single bond, -B($Ar^1$)-, - C($Ar^1$)($Ar^2$)-, -Si($Ar^1$)($Ar^2$)-, -Ge($Ar^1$)($Ar^2$)-, -N($Ar^1$)-, - P($Ar^1$)-, -PO($Ar^1$)-, -O-, -S-, -SO-, -$SO_2$-, -Se-, -SeO-, -$SeO_2$-, -CO-, -CS- or -CSe-, and herein, $Ar^1$ and $Ar^2$ are each independently

hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^1$ and $Ar^2$ may be linked to each other to form a ring, or may each be linked to $Y^2$, R that is linked to $Y^2$, or A to form a fused ring,

when Q is not present, A is not directly linked to $Y^1$ at the second linking position of A,

when Q is a single bond, A is linked to $Y^1$ by a single bond at the second linking position of A,

when Q is not a single bond and is present as any one defined as above, A is linked to Q at the second linking position of A,

when Q is not a single bond and is present as any one defined as above, Q is linked to A and $Y^1$ each by a single bond,

$Y^1$ to $Y^{15}$ are each independently boron, carbon, nitrogen, oxygen, sulfur, Se or Te,

Z is not present, or a single bond, $-B(Ar^3)-$, - $C(Ar^3)(Ar^4)-$ $-Si(Ar^3)(Ar^4)-$, $-Ge(Ar^3)(Ar^4)-$, $-N(Ar^3)-$, - $P(Ar^4)-$, $-PO(Ar^3)-$, -O-, -S-, -SO-, $-SO_2-$, -Se-, -SeO-, $-SeO_2-$, -CO-, -CS- or -CSe-, and herein, $Ar^3$ and $Ar^4$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^3$ and $Ar^4$ may be linked to each other to form a ring, or may each be linked to any one of $Y^7$, $Y^{12}$, R that is linked to $Y^7$ or R that is linked to $Y^{12}$ to form a fused ring,

when Z is not present, $Y^6$ and $Y^{11}$ are not directly linked,

when Z is a single bond, $Y^6$ and $Y^{11}$ are linked by a single bond,

when Z is not a single bond and is present as any one defined as above, Z is linked to $Y^6$ and $Y^{11}$ each by a single bond,

m, n and o are each independently an integer of 0 to 5,

Rs are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent,

allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{101})(R^{102})$, $-C(R^{103})(R^{104})(R^{105})$, - $Si(R^{106})(R^{107})(R^{108})$, $-Ge(R^{109})(R^{110})(R^{111})$, $-N(R^{112})(R^{113})$, - $P(R^{114})(R^{115})$, $-PO(R^{116})(R^{117})$, $-O(R^{118})$, $-S(R^{119})$, $-SO(R^{120})$, - $SO_2(R^{121})$, $Se(R^{122})$, $-SeO(R^{123})$, $-SeO_2(R^{124})$ and combinations thereof,

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom may be linked to form a ring,

at least two Rs present when m, n or o is 2 or greater may be linked to each other to form a ring,

p, q and r each independently represent 0 or 1, and when p, q or r is 0, it means that a 5-membered ring is formed, and when p, q or r is 1, it means that a 6-membered ring is formed,

however, at least one atom of $Y^6$ to $Y^{15}$ and Z is an atom including an unshared electron pair, or R bonding thereto

includes at least one atom including an unshared electron pair,

<Chemical Formula 2>

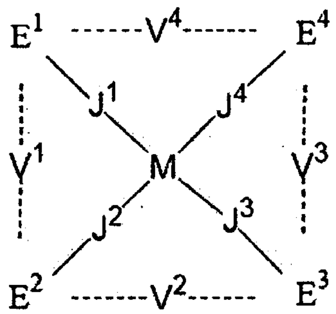

in Chemical Formula 2,

M is a transition metal,

$V^1$, $V^2$, $V^3$ and $V^4$ are each independently not present, or a single bond, -B($Ar^5$)-, -C($Ar^5$)($Ar^6$)-, - Si($Ar^5$)($Ar^6$)-, -Ge($Ar^5$)($Ar^6$)-, -N($Ar^5$)-, -P($Ar^5$)-, -PO($Ar^5$)-, -O-, -S-, -SO-, -$SO_2$-, -Se-, -SeO-, -$SeO_2$-, -CO-, -CS- or - CSe-, and herein, $Ar^5$ and $Ar^6$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^5$ and $Ar^6$ may be linked to each other to form a ring, or may each be linked to adjacent $E^1$, $E^2$, $E^3$ or $E^4$ to form a fused ring,

however, at least one of $V^1$, $V^2$, $V^3$ and $V^4$ is a single bond,

when $V^1$, $V^2$, $V^3$ and $V^4$ are not present, two of the adjacent $E^1$, $E^2$, $E^3$ and $E^4$ are not directly linked,

when $V^1$, $V^2$, $V^3$ and $V^4$ are a single bond, two of the adjacent $E^1$, $E^2$, $E^3$ and $E^4$ are directly linked by a single bond, and when $V^1$, $V^2$, $V^3$ and $V^4$ are not a single bond and are present as any one defined as above, they are linked to two of the adjacent $E^1$, $E^2$, $E^3$ and $E^4$ each by a single bond, or two bonds linked to two of the adjacent $E^1$, $E^2$, $E^3$ and $E^4$ may form a conjugated structure together,

$J^1$, $J^2$, $J^3$ and $J^4$ are each a single bond, O or S,

when $J^1$, $J^2$, $J^3$ and $J^4$ are a single bond, any one of $E^1$, $E^2$, $E^3$ and $E^4$ linked thereto directly bonds to M by a coordination bond or a covalent bond,

when $J^1$, $J^2$, $J^3$ and $J^4$ are O or S, the bond with M is a coordination bond or a covalent bond,

$E^1$, $E^2$, $E^3$ and $E^4$ are each independently a monovalent, divalent or trivalent group and defined as below, provided that, when $E^1$, $E^2$, $E^3$ and $E^4$ are a monovalent group, the adjacent two of $V^1$, $V^2$, $V^3$ and $V^4$ are both absent; when $E^1$, $E^2$, $E^3$ and $E^4$ are a divalent group, any one of the adjacent two of $V^1$, $V^2$, $V^3$ and $V^4$ is not present; and when $E^1$, $E^2$, $E^3$ and $E^4$ are a trivalent group, the adjacent two of $V^1$, $V^2$, $V^3$ and $V^4$ are both present,

$E^1$, $E^2$, $E^3$ and $E^4$ are each independently a monovalent group of halogen or cyano, or saturated or unsaturated aliphatic hydrocarbon having 1 to 50 carbon atoms unsubstituted or substituted with an additional substituent; saturated or unsaturated heteroatom-containing aliphatic hydrocarbon having 1 to 50 carbon atoms unsubstituted or substituted with an additional substituent; an aromatic carbon ring having 5 to 50 carbon atoms unsubstituted or substituted with an additional substituent; an aromatic heteroring having 2 to 50 carbon atoms unsubstituted or substituted with an additional substituent; a saturated or unsaturated alicyclic carbon ring having 3 to 50 carbon atoms unsubstituted or substituted with an additional substituent; or a saturated or unsaturated alicyclic heteroring having 2 to 50 carbon atoms unsubstituted or substituted with an additional substituent,

at least two additional substituents included in $E^1$, $E^2$, $E^3$ and $E^4$ may be linked to form a ring,

however, when $J^1$, $J^2$, $J^3$ or $J^4$ is a single bond, the atom at the linking position from the adjacent $E^1$, $E^2$, $E^3$ or $E^4$ to M is carbon, nitrogen, oxygen, sulfur or phosphorous; or when $J^1$, $J^2$, $J^3$ or $J^4$ is O or S, the atom at the linking position from the adjacent $E^1$, $E^2$, $E^3$ or $E^4$ to O or S of $J^1$, $J^2$, $J^3$ or $J^4$ is carbon,

in any one of $E^1$, $E^2$, $E^3$ and $E^4$, the linking position to the adjacent $J^1$, $J^2$, $J^3$ or $J^4$ and the linking position to the adjacent $V^1$, $V^2$, $V^3$ or $V^4$ are adjacent to each other,

in any one of $E^1$, $E^2$, $E^3$ and $E^4$, the linking positions to two of the adjacent $V^1$, $V^2$, $V^3$ and $V^4$ are different from each other,

an atom capable of bonding according to a stoichiometric ratio except for M in Chemical Formula 2 may be the first linking position or the second linking position of A in Chemical Formula 1, provided that, the first linking position and the second linking position are each (i) different from the linking position from any one of $E^1$, $E^2$, $E^3$ and $E^4$ to the adjacent $J^1$, $J^2$, $J^3$, $J^4$, $V^1$, $V^2$, $V^3$ or $V^4$, and (ii) different from the linking position from any one of $V^1$, $V^2$, $V^3$ and $V^4$ to the adjacent $E^1$, $E^2$, $E^3$ or $E^4$,

the first linking position and the second linking position are adjacent to each other, and

the additional substituents may be present in the numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms.

In the definition of Chemical Formula 1, when $Ar^1$ or $Ar^2$ that is not hydrogen and deuterium of Q is linked to $Y^2$ or R that is linked to $Y^2$ to form a fused ring, it includes a case in which R that is linked to $Y^2$ is hydrogen, and as R, the hydrogen, is eliminated, $Ar^1$ or $Ar^2$ is linked to $Y^2$.

In the definition of Chemical Formula 1, when $Ar^3$ or $Ar^4$ of Z is linked to any one of $Y^7$, $Y^{12}$, R that is linked to $Y^7$ and R that is linked to $Y^{12}$ to form a fused ring, it includes a case in which R that is linked to $Y^7$ or R that is linked to $Y^{12}$ is hydrogen, and as R, the hydrogen, is eliminated, $Ar^3$ or $Ar^4$ is linked to $Y^7$ or $Y^{12}$.

When at least two Rs are linked to form a ring in Chemical Formula 1, such a ring includes a fused ring. In addition, when two Rs are linked, it includes a case in which any one R of the linked two Rs is hydrogen, and as R, the hydrogen, is eliminated, the other R of the two Rs is directly linked to any one of $Y^1$ to $Y^{15}$ to which R, the hydrogen, is linked.

In Chemical Formula 2, when at least two additional substituents included in $E^1$, $E^2$, $E^3$ and $E^4$ are linked to form a ring, such a ring includes a fused ring. The two additional substituents forming such a ring may be additional substituents each linked to any one or two of $E^1$, $E^2$, $E^3$ and $E^4$. In addition, when two additional substituents are linked, it includes case in which any one of the linked two is hydrogen, and these are linked as the hydrogen is eliminated.

In the definition of Chemical Formula 2, the atom at the linking position linked to $J^1$, $J^2$, $J^3$, $J^4$ or M in $E^1$, $E^2$, $E^3$ and $E^4$ may be an atom included in aliphatic hydrocarbon, heteroatom-containing aliphatic hydrocarbon, an aromatic carbon ring, an aromatic heteroring, an alicyclic carbon ring or an alicyclic heteroring defined for $E^1$, $E^2$, $E^3$ and $E^4$, or an atom included in additional substituents linked thereto.

The multifunctional compound is a compound represented by Chemical Formula 1 chemical-structurally designed to have an increased rate constant value related to an energy transfer rate, and may improve luminous efficiency of an organic light-emitting diode.

The multifunctional compound may readily implement various colors including a deep blue color, and may also improve quantum efficiency of an organic light-emitting diode.

The multifunctional compound represented by Chemical Formula 1 is designed to be divided into an atom represented by X, a light-emitting moiety and an excited complex-forming moiety: the light-emitting moiety and the excited complex-forming moiety are linked through the atom represented by X, and the atom represented by X is X presented in Chemical Formula 1. The light-emitting moiety includes A, a conjugated ring formed to include $Y^1$ to $Y^5$, and Q in Chemical Formula 1. The excited complex-forming moiety includes a conjugated ring formed to include $Y^6$ to $Y^{10}$, a conjugated ring formed to include $Y^{11}$ to $Y^{15}$, and Z in Chemical Formula 1.

The excited complex-forming moiety may form an excited complex together with an excited complex-forming compound described below.

The multifunctional compound is a compound in which the light-emitting moiety bonds to the excited complex-forming moiety that may form an excited complex with an excited complex-forming compound via the atom represented by X.

A mechanism of the excited complex is a phenomenon occurring between two molecules, and one molecule

becomes excited (excited state) first by absorbing light corresponding to a HOMO-LUMO gap, and interacts with another molecule in the vicinity to form an excited complex. When the excited complex emits light, the two molecules return to their original states.

When separately defining the excited complex in a narrow sense, it is called an excited dimer or excimer when the two molecules are the same molecules, and called an excited complex or exciplex when the two molecules are heterogeneous molecules. Alternatively, the excited complex is also named separately as an electroplex. The electroplex is an excited complex or excited dimer formed when an electric field is applied inside an organic light-emitting diode (OLED) device. In the present specification, the term 'excited complex' is defined in a broad sense, and needs to be understood to include all concepts of excited dimer, excimer, excited complex, exciplex and electroplex.

The excited complex-forming moiety is designed as a moiety induced from any one of two molecules forming the excited complex, and the other one of the two molecules forming the excited complex becomes the above-described excited complex-forming compound. For the convenience of distinction, the two molecules forming the excited complex are each distinguishably referred to as a first excited complex-forming compound and a second excited complex-forming compound, and the excited complex-forming moiety is induced from the first excited complex-forming compound, and may form the excited complex with the second excited complex-forming compound.

When a material having small ionization energy and a material having large electron affinity are used together in a light-emitting layer in an organic light-emitting diode device, an excited complex is formed during a process of electron migration. When a light-emitting compound is mixed with this excited complex as a dopant, the dopant absorbs exciton energy of the excited complex to cause light emission. In order to cause such light emission, efficiency of energy transfer from the excited complex to the dopant needs to be high. The method of energy transfer includes a method by light of the following Mathematical Formula 1 (FRET, Förster Resonance Energy transfer ) and a method by electron of the following Mathematical Formula 2 (Dexter Electron Transfer).

FRET (Förster Resonance Energy transfer)

[Mathematical Formula 1]

$$k_{ET} = \left(\frac{1}{r^6 \tau_D}\right)\left(\frac{2.07\kappa^2 Q_D J}{128\pi^5 N_A n^4}\right)$$

Dexter Electron Transfer

[Mathematical Formula 2]

$$k_{ET} \propto J exp^{\left(-\frac{2r}{L}\right)}$$

$k_{ET}$: rate constant
r: distance between energy donor and energy acceptor
$\tau_D$: PL decay time of energy donor
$\kappa$: orientation factor
$Q_D$: PL quantum efficiency of energy donor
$N_A$: Avogadro number
n: refractive index
J: defined by Mathematical Formula 3.

[Mathematical Formula 3]

$$J = \int f_D(\lambda)\varepsilon_A(\lambda)\lambda^4 d\lambda$$

$f_D$: emission spectrum of energy donor
$\varepsilon_A$: extinction coefficient depending on wavelength of energy acceptor
L: sum of Van der Waals radii
$\lambda$: wavelength

The inventors of the present invention have derived the multifunctional compound as a novel compound that allows r to approach 0 in Mathematical Formula 1 and Mathematical Formula 2. The inventors of the present invention deduce an advantage when r approaches 0 as follows.

Regardless of whether the energy transfer method is the method by light of Mathematical Formula 1 or by the method by electron of Mathematical Formula 2, what is important is a distance (r) between an energy donor (excited complex) and an energy acceptor (dopant). When a distance (r) approaches 0 in Mathematical Formula 1 of energy transfer by light, quantum efficiency and decay time of the energy donor (excited complex) become unimportant, and theoretically, the energy transfer rate approaches infinity. On the other hand, when a distance (r) between two molecules approaches 0 in Mathematical Formula 2, an energy transfer method by electron migration, the energy transfer rate is only affected by the degree of overlap (J) between emission spectrum and absorption spectrum between the two molecules.

The multifunctional compound is designed as a compound obtained by combining any one of the two molecules forming the excited complex (corresponding to the first excited complex-forming compound) and the dopant (corresponding to the light-emitting compound inducing the light-emitting moiety). When applying the concepts of Mathematical Formula 1 and Mathematical Formula 2 to the multifunctional compound, the distance is fixed and minimized when any one of the two molecules forming the excited complex and the dopant are combined in the multifunctional compound, and accordingly, exciton energy formed in the excited complex is transferred to the dopant at a high rate, emitting light.

The excited complex-forming moiety in the multifunctional compound is induced (or derived) from the first excited complex-forming compound, and therefore, may form an excited complex with the second excited complex-forming compound.

FIG. 1 is a diagram illustrating a working mechanism of the multifunctional compound.

FIG. 1 shows a multifunctional compound formed by linking the first excited complex-forming compound having large HOMO-LUMO gap energy and the light-emitting compound having relatively small HOMO-LUMO gap energy through chemical bonding. When the excited complex-forming moiety, which is induced from the first excited complex-forming compound in the multifunctional compound, is excited, energy is transferred to the light-emitting moiety induced from the light-emitting compound.

The phenomenon of the excited complex energy being transferred from the excited complex made by interaction between the excited complex-forming moiety and the (second) excited complex-forming compound to the light-emitting moiety may be identified by manufacturing an organic light-emitting diode. In other words, when charges are injected into a light-emitting layer of an organic light-emitting diode, the excited complex-forming moiety and the (second) excited complex-forming compound inside the multifunctional compound make an excited complex first, and energy of this excited complex is transferred to the light-emitting moiety through the excited complex moiety. When the energy of the excited complex formed in the excited complex is larger than the energy of the light-emitting moiety, the excited complex energy is transferred to the light-emitting moiety.

Meanwhile, it is presumed that when such an excited complex is formed in an organic light-emitting diode in which the multifunctional compound is used, excited energy of the excited complex is transferred to the light-emitting moiety in one molecule of the multifunctional compound, and in addition thereto, some of the energy may also be transferred to the light-emitting moiety of another multifunctional compound very adjacent to the excited complex. This is due to the fact that there is a probability that the intermolecular distance of the light-emitting moiety between the multifunctional compound having the excited complex formed and another multifunctional compound that is spatially very adjacent thereto is close to 0 in Mathematical Equation 1 and Mathematical Equation 2, and energy may be efficiently transferred at this time.

FIG. 2 schematically illustrates a mechanism in which excited energy of the excited complex is transferred between the moieties in the multifunctional compound to emit light in an organic light-emitting diode according to one embodiment of the present invention.

The excited complex-forming moiety or the (second) excited complex-forming compound absorbs energy from the outside to form an excited complex, and excited energy of this excited complex is transferred to the light-emitting moiety linked through chemical bonding, and a phenomenon of light emission occurs in the light-emitting moiety.

In more detail, when charges are injected into a light-emitting layer including the excited complex-forming moiety of the multifunctional compound inside an organic light-emitting diode, the excited complex-forming moiety and the (second) excited complex-forming compound included in the organic light-emitting diode so as to be adjacent thereto interact to form an excited complex, and energy of the excited complex formed as above is transferred to the light-emitting moiety that is present very close within one molecule of the multifunctional compound. Such an energy transfer between moieties in the multifunctional compound is performed with high efficiency and at a high rate since the distance r approaches almost 0 in Mathematical Formulae 1 and 2, which significantly increases the rate constant. The excited

complex energy is transferred to the light-emitting moiety, and the light-emitting moiety may emit light with minimal energy loss, and as a result, the multifunctional compound may implement a mechanism capable of emitting light with high efficiency using the excited complex energy, and an effect of improving energy efficiency is obtained therefrom.

As the organic light-emitting diode including the multifunctional compound uses an excited complex, energy is effectively transferred between moieties in the multifunctional compound while having an advantage of reducing an energy difference between a singlet and a triplet, and as the organic light-emitting diode including the multifunctional compound includes the light-emitting moiety, high quantum efficiency may be obtained by efficiently transferring energy while readily implementing various colors including a deep blue color.

The multifunctional compound is not limited to the application of implementing a blue color, and may be applied to emissions of all green, red and near infrared light.

The light-emitting moiety may be induced from a light-emitting material (referred to as light-emitting compound in the present specification) capable of emitting light by electron migration in an organic light-emitting diode.

The light-emitting compound (light-emitting material) may be a compound that may be commonly used as a dopant in an organic light-emitting diode. A dopant capable of implementing a desired color is selected as the light-emitting compound depending on the purpose, and the light-emitting moiety may be induced therefrom.

In one embodiment, M in Chemical Formula 2 may be Rh, Ir, Pd, Pt, Ni, Rh, Co or Au.

In one embodiment, A may be represented by the following Chemical Formula 3.

<Chemical Formula 3>

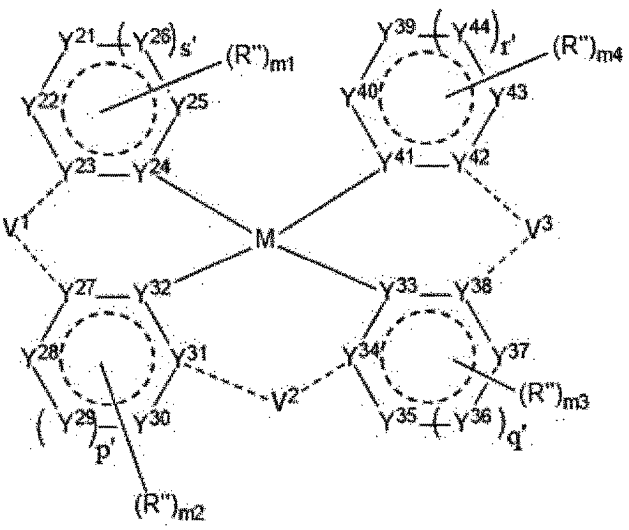

In Chemical Formula 3,

M is Pt,
$V^1$, $V^2$ and $V^3$ have the same definitions as in Chemical Formula 2,
s', p', q' and r' are each 0 or 1,
m1, m2, m3 and m4 are each an integer of 1 to 5,
$Y^{21}$ to $Y^{44}$ are each independently B, N, C, O, P, Si, S, Ge or Se, and the ring including a circle marked by a dotted line may not have a conjugated structure, or may partially or fully have a conjugated structure,
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or

substituted with an additional substituent, $-B(R^{301})(R^{302})$, $-C(R^{303})(R^{304})(R^{305})$, $-Si(R^{306})(R^{307})(R^{308})$, $-Ge(R^{309})(R^{310})(R^{311})$, $-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof,
$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom may be linked to form a ring, and
the additional substituent has the same definition as in Chemical Formula 1.

In one embodiment, A may be represented by any one of the following Chemical Formula 4 to Chemical Formula 8.

<Chemical Formula 4>

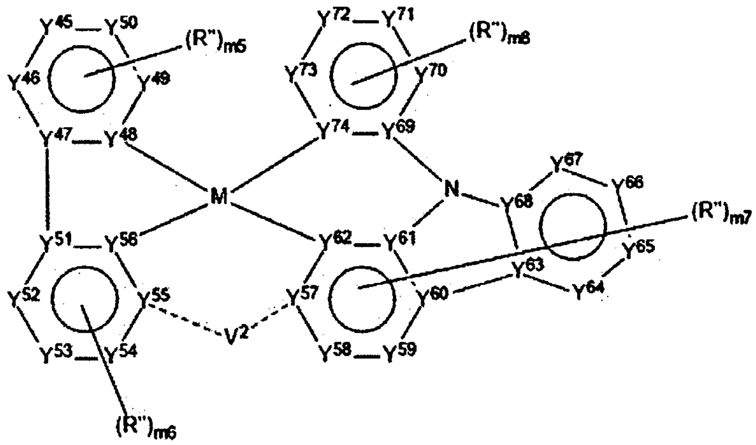

<Chemical Formula 5>

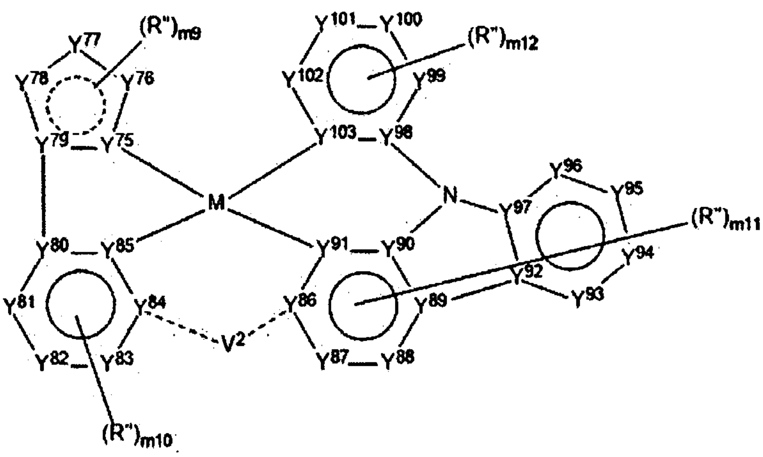

<Chemical Formula 6>

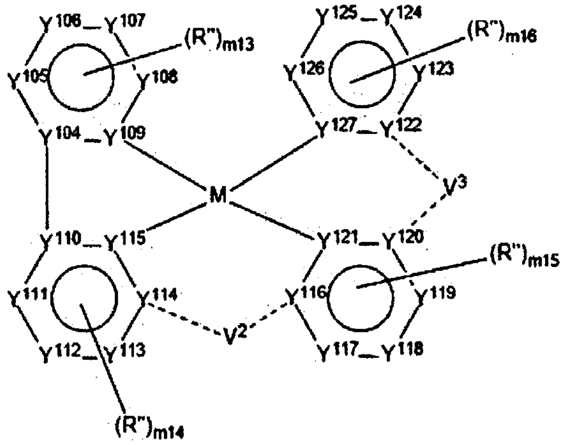

<Chemical Formula 7>

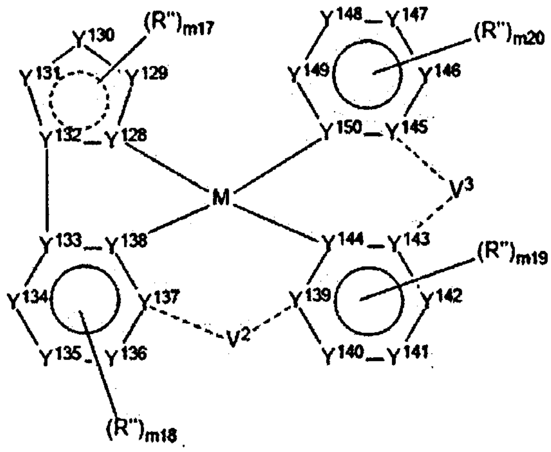

<Chemical Formula 8>

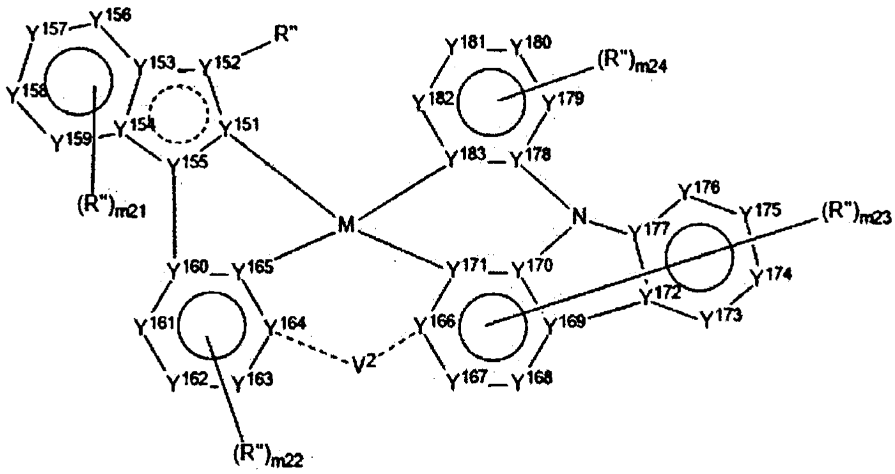

In Chemical Formula 4 to Chemical Formula 8,

M is Pt,

$V^2$ and $V^3$ are each independently not present, or a single bond, -B($Ar^5$)-, -N($Ar^5$)-, -O-, -S- or -Se-, and $Ar^5$s are each independently aryl having 6 to 30 carbon atoms unsubstituted or substituted with an additional substituent, heteroaryl having 2 to 30 carbon atoms unsubstituted or substituted with an additional substituent, alkyl having 1 to 30 carbon atoms unsubstituted or substituted with an additional substituent, cycloalkyl having 3 to 30 carbon atoms unsubstituted or substituted with an additional substituent, heterocycloalkyl having 2 to 30 carbon atoms unsubstituted or substituted with an additional substituent, cycloalkenyl having 3 to 30 carbon atoms unsubstituted or substituted with an additional substituent, or heterocycloalkenyl having 2 to 30 carbon atoms unsubstituted or substituted with an additional substituent,

m5, m6, m8, m10, m12, m13, m14, m18, m21, m22 and m24 are each an integer of 1 to 4,

m15, m16, m19 and m20 are each an integer of 1 to 5,

m7, m11 and m23 are each an integer of 1 to 7,

m9 and m17 are each an integer of 1 to 3,

$Y^{45}$ to $Y^{74}$, $Y^{80}$ to $Y^{127}$, $Y^{133}$ to $Y^{150}$, and $Y^{156}$ to $Y^{183}$ are each independently B, N or C,

$Y^{75}$ to $Y^{79}$, $Y^{128}$ to $Y^{132}$, and $Y^{151}$ to $Y^{155}$ are each independently B, N, C, O, S, Se, Te, Si, Ge or Sn,

the ring including a circle marked by a dotted line in Chemical Formula 5, Chemical Formula 7 and Chemical Formula 8 may not have a conjugated structure, or may partially or fully have a conjugated structure,

R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, -B($R^{301}$)($R^{302}$),-C($R^{303}$)($R^{304}$)($R^{305}$), -Si($R^{306}$)($R^{307}$)($R^{308}$), -Ge($R^{309}$)($R^{310}$)($R^{311}$),-N($R^{312}$)($R^{313}$), -P($R^{314}$)($R^{315}$), -PO($R^{316}$)($R^{317}$), -O($R^{318}$), -S($R^{319}$), -SO($R^{320}$), $-SO_2$($R^{321}$), Se($R^{322}$), -SeO($R^{323}$), $-SeO_2$($R^{324}$) and combinations thereof,

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom may be linked to form a ring, and

the additional substituent has the same definition as in Chemical Formula 1.

In one embodiment, A may be represented by any one of the following Structural Formulae A-1 to A-27.

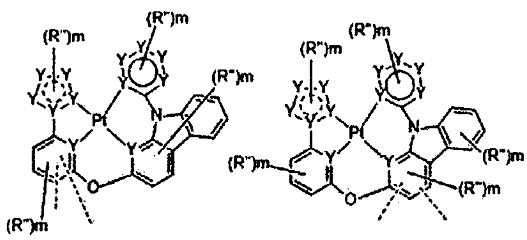

A-1 A-2

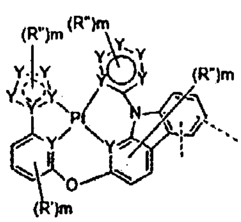

A-3

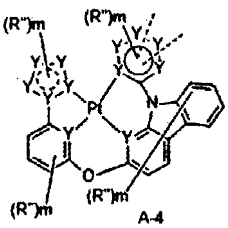
A-4

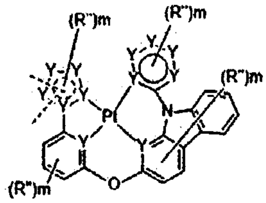
A-5

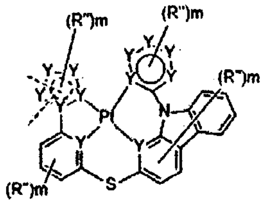
A-6

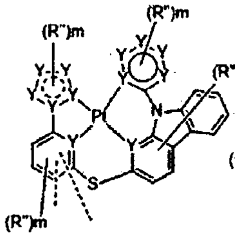
A-7

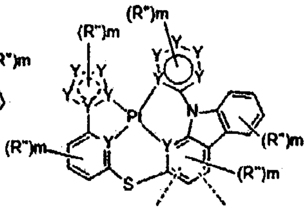
A-8

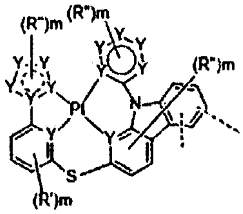
A-9

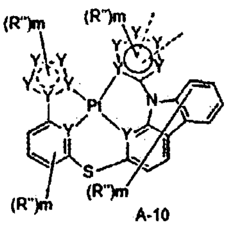
A-10

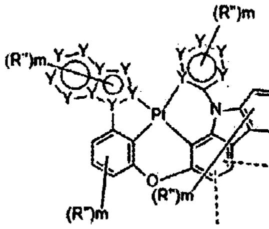
A-11

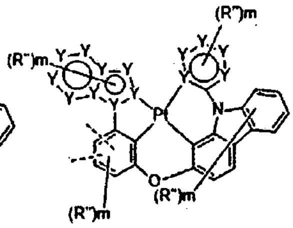
A-12

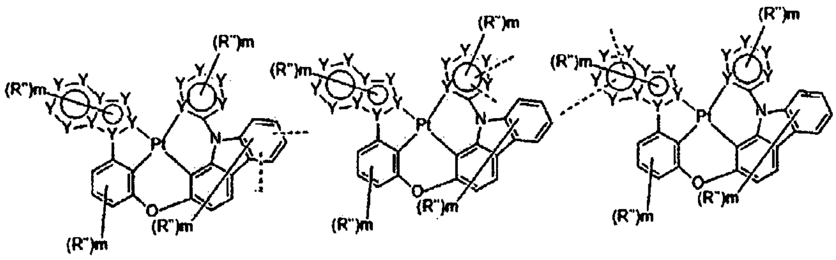
A-13

A-14

A-15

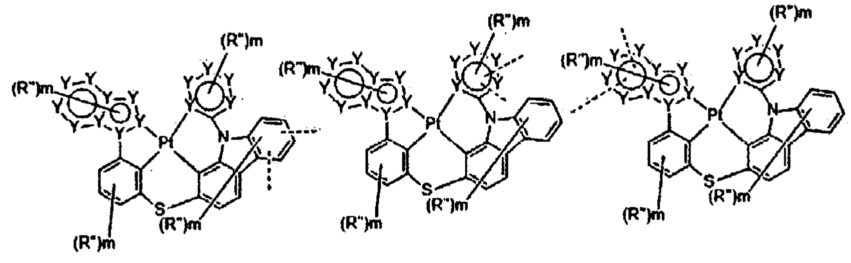

A-13 A-14 A-15

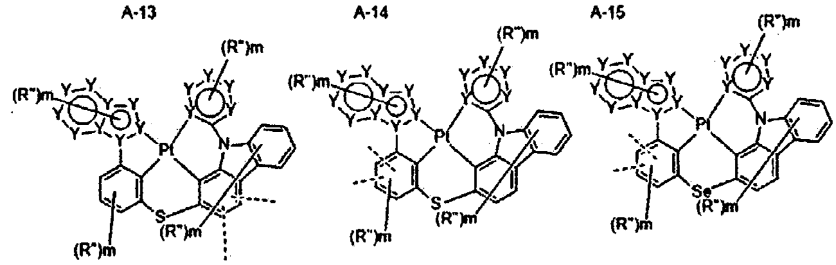

A-16 A-17 A-18

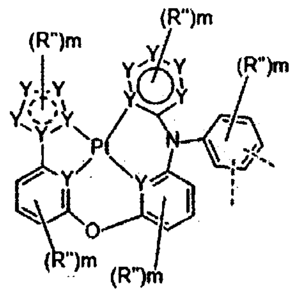

A-19

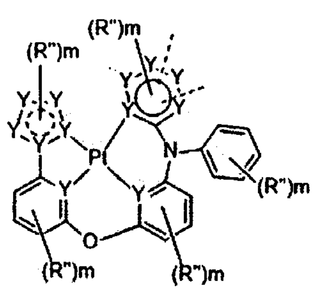

A-20

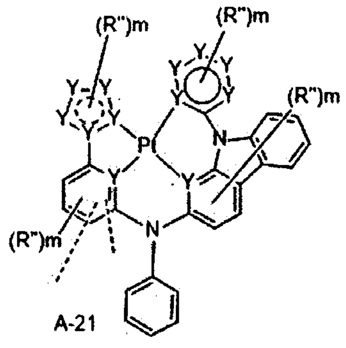

A-21

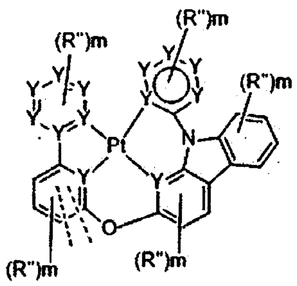

A-22

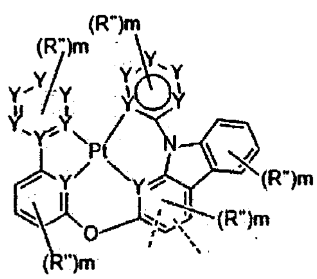

A-23

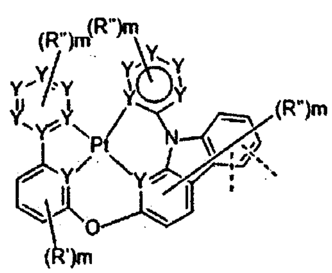

A-24

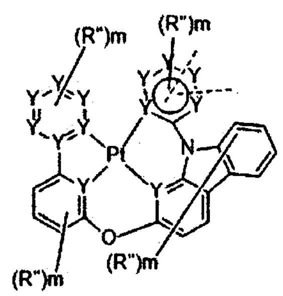

A-25

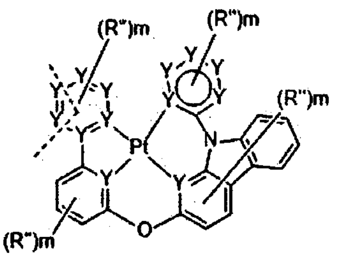

A-26

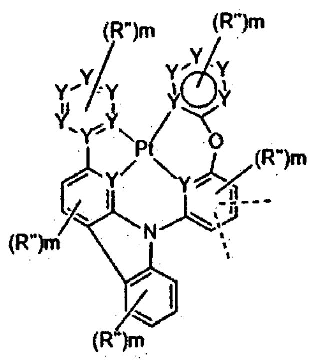

A-27

In A-1 to A-27,

Ys are each independently B, N, C, O, P, Si, S, Ge or Se,

m is an integer of 0 to a maximum number capable of having according to a stoichiometric ratio,

R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$,$-C(R^{303})(R^{304})(R^{305})$, $-Si(R^{306})(R^{307})(R^{308})$, $-Ge(R^{309})(R^{310})(R^{311})$,$-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof,

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom may be linked to form a ring, and

the additional substituent has the same definition as in Chemical Formula 1.

In A-1 to A-27, when at least two of R"s are linked to each other to form a ring, such a ring includes a fused ring. In addition, when two of R"s are linked, it includes a case in which any one of the two R"s is hydrogen, and as the hydrogen is eliminated, the other R" is directly linked due to the reduction of the ring to which the hydrogen is linked.

The light-emitting mechanism of the light-emitting moiety may include fluorescence that light is emitted from a singlet, phosphorescence that light is emitted from a triplet, and thermally activated delayed fluorescence that light is emitted by transferring energy from a triplet to a singlet.

In one embodiment, the second excited complex-forming compound may not form an excited complex with the light-emitting moiety. When the light-emitting moiety is capable of forming an excited complex with the second excited complex-forming compound, it may affect an emission wavelength of the light-emitting moiety. It is due to the fact that, when an emission wavelength of the light-emitting moiety changes, it may be difficult to apply properties of a light-emitting compound known in the art to the light-emitting moiety when designing color implementation, or, when a desired light-emitting compound is to be used to implement a specific color, it may be difficult to implement a desired color as an emission wavelength of the light-emitting moiety changes.

In one embodiment, Chemical Formula 1 may be any one of chemical formulae represented by the following B-1 to B-28.

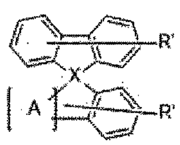

B-1

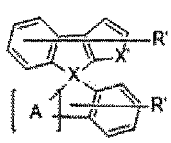

B-2

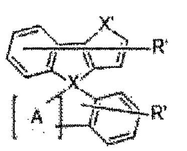

B-3

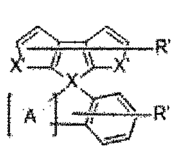

B-4

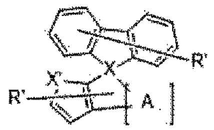
B-5

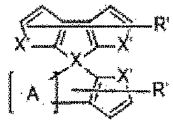
B-6

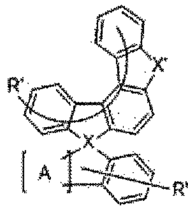
B-7

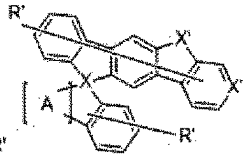
B-8

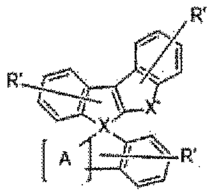
B-9

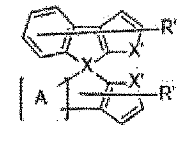
B-10

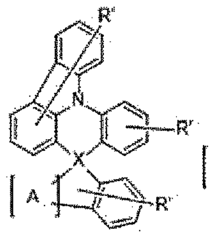
B-11

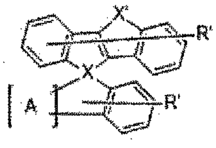
B-12

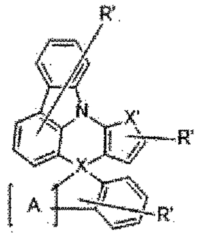
B-13

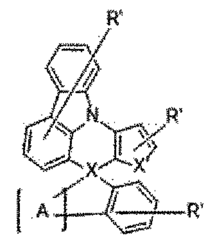
B-14

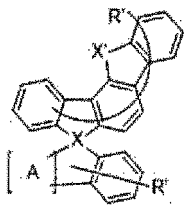
B-15

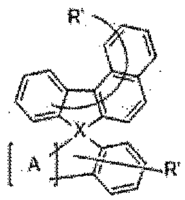
B-16

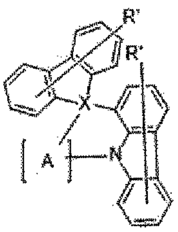
B-17

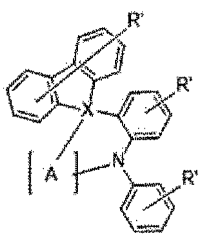
B-18

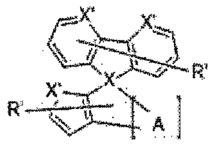
B-19

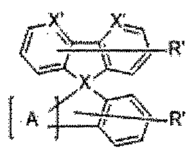
B-20

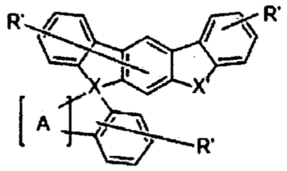
B-21

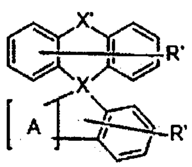
B-22

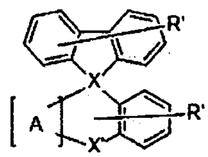
B-23

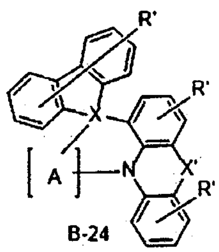
B-24

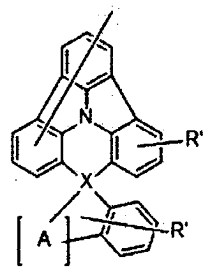
B-25

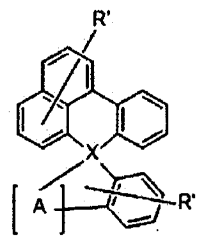
B-26

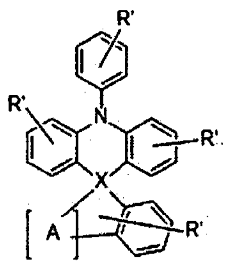
B-27

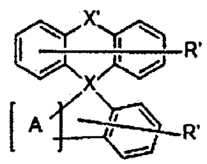
B-28

In B-1 to B-28,

A and X have the same definitions as in Chemical Formula 1,
X's linked by =X'- are each independently $=C(Ar^7)-$, =N- or =B-,
X's linked by -X'- are each independently -O-,-S-, -Se-, $-C(Ar^7)(Ar^8)-$, $-Si(Ar^7)(Ar^8)$ or $-N(Ar^7)-$,
$Ar^7$ and $Ar^8$ in the definition of X' are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^7$ and $Ar^8$ may be linked to each other to form a ring, or may each be linked to an adjacent ring to form a fused ring,
R's may be present in the numbers capable of bonding according to a stoichiometric ratio, and are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{101})(R^{102})$, $-C(R^{103})(R^{104})(R^{105})$,$-Si(R^{106})(R^{107})(R^{108})$, $-Ge(R^{109})(R^{110})(R^{111})$, $-N(R^{112})(R^{113})$,$-P(R^{114})(R^{115})$, $-PO(R^{116})(R^{117})$, $-O(R^{118})$, $-S(R^{119})$, $-SO(R^{120})$,$-SO_2(R^{121})$, $Se(R^{122})$, $-SeO(R^{123})$, $-SeO_2(R^{124})$ and combinations thereof,
$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least of $R^{101}$ to $R^{124}$ two linked to one atom may be linked to form a ring, and
the additional substituent has the same definition as in Chemical Formula 1.

The first excited complex-forming compound (the excited complex-forming moiety in the multifunctional compound is induced therefrom) and the second excited complex-forming compound are, as described above, compounds capable of forming an excited complex, and as a result, the excited complex-forming moiety and the second excited complex-forming compound form an excited complex. The excited complex may be formed between an electron donor molecule having small ionization energy and an electron acceptor molecule having large electron affinity.
Accordingly, the excited complex-forming moiety (or the first excited complex-forming compound) and the second excited complex-forming compound may be in a relationship of a pair of electron donor molecule and electron

acceptor molecule. For example, the excited complex-forming moiety (or the first excited complex-forming compound) and the second excited complex-forming compound may be an electron donor molecule and an electron acceptor molecule, respectively, or vice versa.

In one embodiment, the excited complex-forming moiety may be an electron donor or an electron acceptor including an atom having at least one unshared electron pair.

In one embodiment, the excited complex-forming moiety includes at least one atom having an unshared electron pair included in a wave function of HOMO or LUMO of the excited complex-forming moiety. Herein, the criterion for defining the HOMO and LUMO wave functions of the excited complex-forming moiety is obtained by calculation using DFT based on a structure in which the linkage between the light-emitting moiety and X is broken and the linking site is substituted with hydrogen or $-CH_3$.

In one embodiment, in Chemical Formula 1,

at least one of $Y^6$ to $Y^{15}$; and atoms of Z linked to $Y^6$ and $Y^{11}$ is an atom having an unshared electron pair included in a wave function of HOMO or LUMO of the excited complex-forming moiety; or
at least one of $Y^6$ to $Y^{15}$ has R represented by the following Chemical Formula 9 or the following Chemical Formula 10.

<Chemical Formula 9>

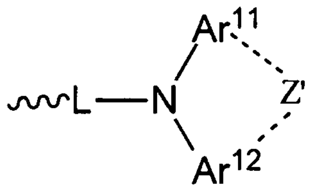

<Chemical Formula 10>

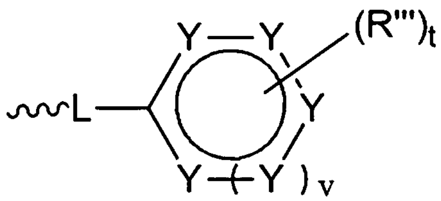

In Chemical Formula 9 and Chemical Formula 10,

L is a single bond, or a divalent group selected from the group consisting of alkylene having 1 to 20 carbon atoms, cycloalkylene having 3 to 20 carbon atoms, cycloalkenylene having 3 to 20 carbon atoms, heteroalkylene having 1 to 20 carbon atoms, heterocycloalkylene having 2 to 20 carbon atoms, heterocycloalkenylene having 2 to 20 carbon atoms, alkenylene having 2 to 20 carbon atoms, -O-, -S-,-P($R^{401}$)-, -PO($R^{402}$)-, arylene having 6 to 20 carbon atoms, heteroarylene having 2 to 20 carbon atoms and combinations thereof,

$Ar^{11}$ and $Ar^{12}$ are each independently a monovalent group or a divalent group of saturated or unsaturated aliphatic hydrocarbon having 1 to 20 carbon atoms unsubstituted or substituted with an additional substituent; saturated or unsaturated heteroatom-containing aliphatic hydrocarbon having 1 to 20 carbon atoms unsubstituted or substituted with an additional substituent; an aromatic carbon ring having 5 to 20 carbon atoms unsubstituted or substituted with an additional substituent; an aromatic heteroring having 2 to 20 carbon atoms unsubstituted or substituted with an additional substituent; a saturated or unsaturated alicyclic carbon ring having 3 to 20 carbon atoms unsubstituted or substituted with an additional substituent; or a saturated or unsaturated alicyclic heteroring having 2 to 20 carbon atoms unsubstituted or substituted with an additional substituent,

Z' is not present, or a single bond, -B($Ar^{13}$)-,-C($Ar^{13}$)($Ar^{14}$)-, -Si($Ar^{13}$)($Ar^{14}$)-, -Ge($Ar^{13}$)($Ar^{14}$)-, -N($Ar^{13}$)-,-P($Ar^{13}$)-, -PO($Ar^{13}$)-, -O-, -S-, -SO-, $-SO_2-$, -Se-, -SeO-,$-SeO_2-$, -CO-, -CS- or -CSe-, and herein, $Ar^{13}$ and $Ar^{14}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms

unsubstituted or substituted with an additional substituent, or heteroaryl having 2 to 30 carbon atoms unsubstituted or substituted with an additional substituent, and $Ar^{13}$ and $Ar^{14}$ may be linked to each other to form a ring, or may each be linked to any one of $Ar^{11}$ and $Ar^{12}$ to form a fused ring,

when Z' is not present, $Ar^{11}$ and $Ar^{12}$ are not directly linked,

when Z' is a single bond, $Ar^{11}$ and $Ar^{12}$ are linked by a single bond,

t is an integer of 0 to 5,

v is 0 or 1,

R'"s are each independently at least one selected from the group consisting of hydrogen, deuterium, halogen, cyano, $-NO_2$, alkyl having 1 to 30 carbon atoms, heteroalkyl having 1 to 30 carbon atoms, cycloalkyl having 3 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{501})(R^{502})$, $-C(R^{503})(R^{504})(R^{505})$, $-Si(R^{506})(R^{507})(R^{508})$, $-Ge(R^{509})(R^{510})(R^{511})$, $-N(R^{512})(R^{513})$,$-P(R^{514})(R^{515})$, $-PO(R^{516})(R^{517})$, $-O(R^{518})$, $-S(R^{519})$, $-SO(R^{520})$,$-SO_2(R^{521})$, $Se(R^{522})$, $-SeO(R^{523})$, $-SeO_2(R^{524})$ and combinations thereof, and herein, at least two R'"s may be linked to each other to form a ring,

$R^{401}$ to $R^{402}$ and $R^{501}$ to $R^{524}$ are each independently hydrogen, deuterium, halogen, alkyl having 1 to 30 carbon atoms, cycloalkyl having 3 to 30 carbon atoms, heteroalkyl having 1 to 30 carbon atoms, heterocycloalkyl having 2 to 30 carbon atoms, aryl having 6 to 30 carbon atoms, or heteroaryl having 2 to 30 carbon atoms, and at least two of $R^{401}$ to $R^{402}$ and $R^{501}$ to $R^{524}$ linked to one atom may be linked to form a ring,

Ys are each independently nitrogen, oxygen, sulfur or carbon,

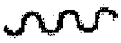 represents a linking site,

the additional substituents may be present in the numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms,$-B(R^{201})(R^{202})$, $-C(R^{203})(R^{204})(R^{205})$, $Si(R^{206})(R^{207})(R^{208})$,$-Ge(R^{209})(R^{210})(R^{211})$, $-N(R^{212})(R^{213})$, $-P(R^{214})(R^{215})$,$-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms,

however, in Chemical Formula 10, L or R'" includes at least one atom having an unshared electron pair included in a wave function of HOMO or LUMO of the excited complex-forming moiety, or at least one of Ys is nitrogen, oxygen or sulfur.

When at least two R'"s are linked to form a ring in Chemical Formula 10, such a ring includes a fused ring. In addition, when two R'"s are linked, it includes a case in which any one R'" of the linked two is hydrogen, and as R'", the hydrogen, is eliminated, the other R'" is directly linked to Y to which R'", the hydrogen, is linked.

In one embodiment, at least one R included in Chemical Formula 1 may be represented by any one of structures of the following Chemical Formulae D-1 to D-38.

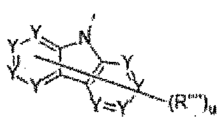

D-1

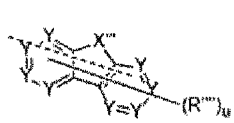

D-2

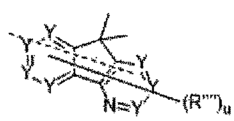

D-3

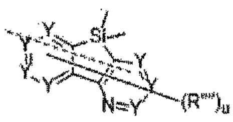

D-4

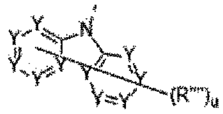

D-5

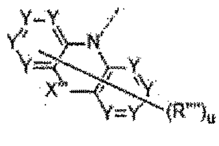

D-6

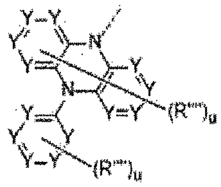

D-7

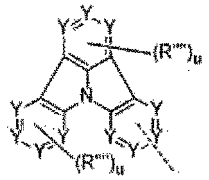

D-8

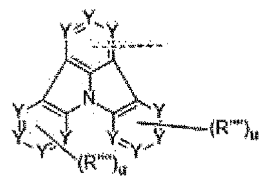

D-9

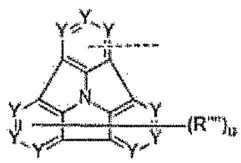

D-10

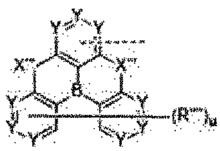

D-11

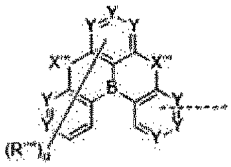

D-12

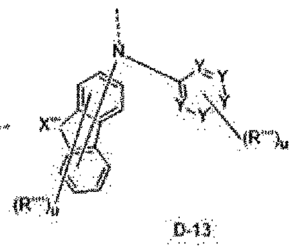

D-13

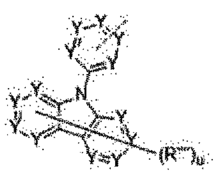

D-14

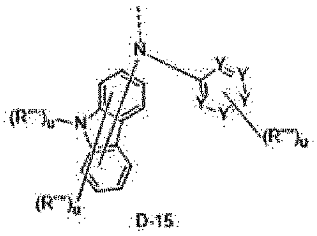

D-15

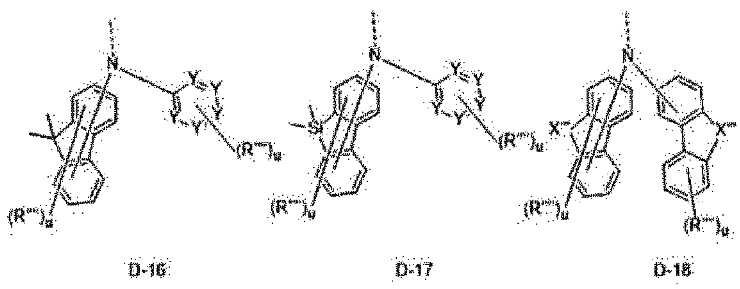

D-16 D-17 D-18

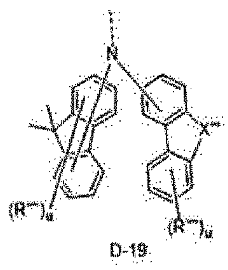

D-19

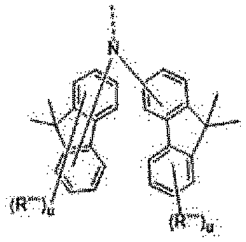

D-20

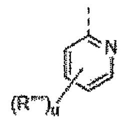

D-21

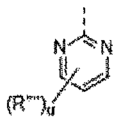

D-22

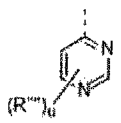

D-23

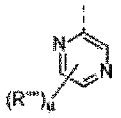

D-24

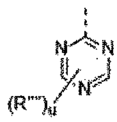

D-25

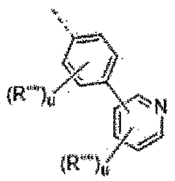

D-26

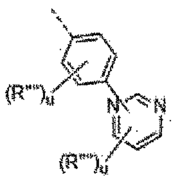

D-27

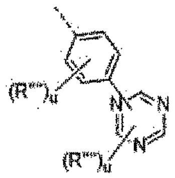

D-28

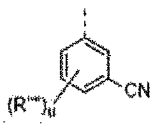

D-29

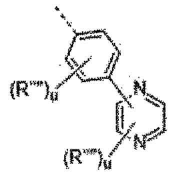

D-30

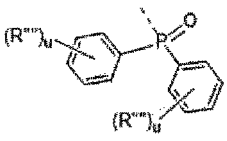

D-31

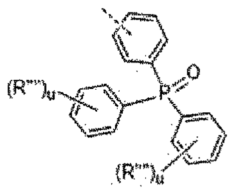

D-32

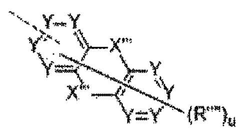

D-33

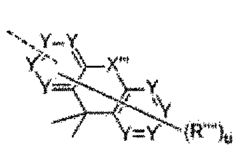

D-34

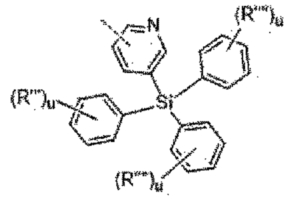

D-35

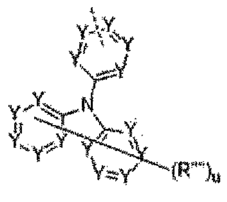

D-36

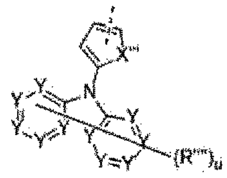

D-37

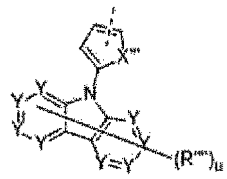

D-38

In Chemical Formulae D-1 to D-38,

Ys are each independently carbon or nitrogen,
X' "s are each independently oxygen, nitrogen, sulfur or selenium,
R""s are each independently selected from the group consisting of hydrogen, deuterium, halogen, cyano, - $NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{601})(R^{602})$, $-C(R^{603})(R^{604})(R^{605})$,$-Si(R^{606})(R^{607})(R^{608})$, $-Ge(R^{609})(R^{610})(R^{611})$, $-N(R^{612})(R^{613})$,$-P(R^{614})(R^{615})$, $-PO(R^{616})(R^{617})$, $-O(R^{618})$, $-S(R^{619})$, $-SO(R^{620})$,$-SO_2(R^{621})$, $Se(R^{622})$, $-SeO(R^{623})$, $-SeO_2(R^{624})$ and combinations thereof, and $R^{601}$ to $R^{624}$ are each independently selected from hydrogen, deuterium, alkyl having 1 to 30 carbon atoms, cycloalkyl having 3 to 30 carbon atoms, heterocycloalkyl having 2 to 30 carbon atoms, aryl having 6 to 30 carbon atoms, heteroaryl having 2 to 30 carbon atoms and combinations thereof,
us are each independently an integer of 0 to 20, and
the dotted line represents a linking site.

In one embodiment, the multifunctional compound may include at least one deuterium.

In one embodiment, the multifunctional compound represented by Chemical Formula 1 may be any one of the following compounds, but is not limited thereto.

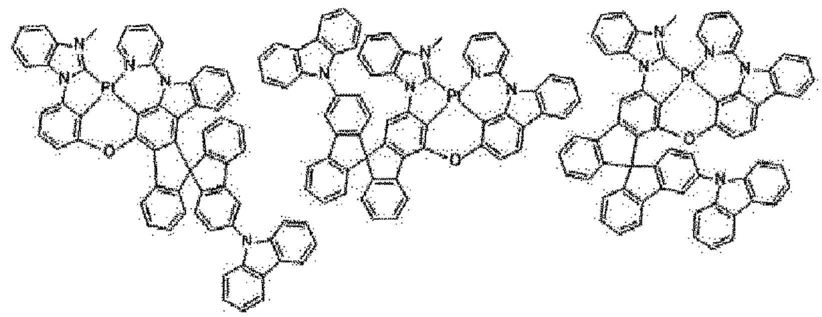

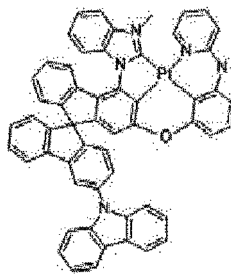

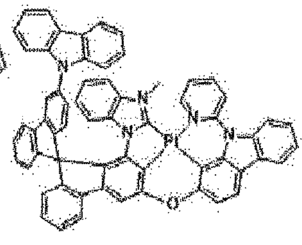

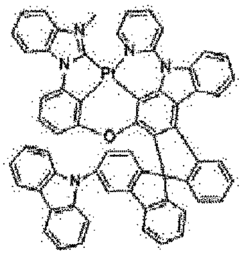

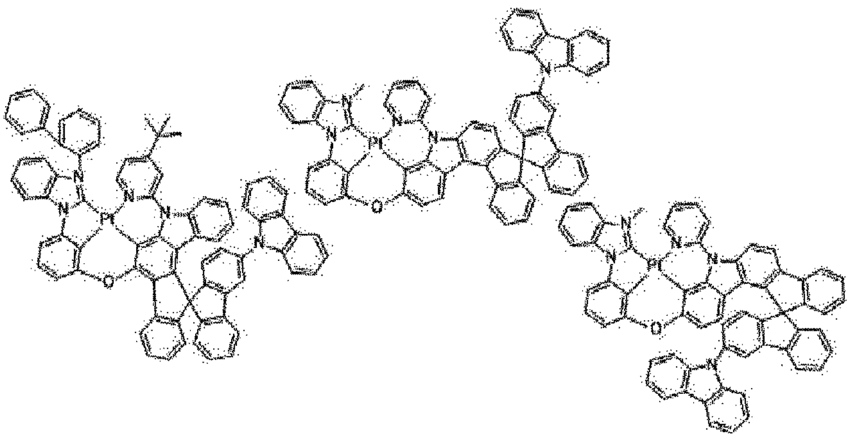

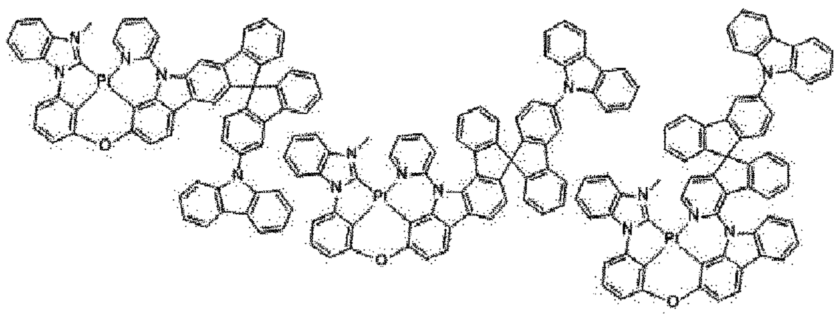

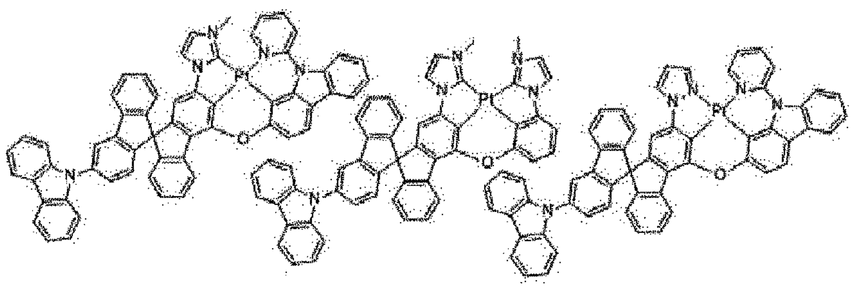

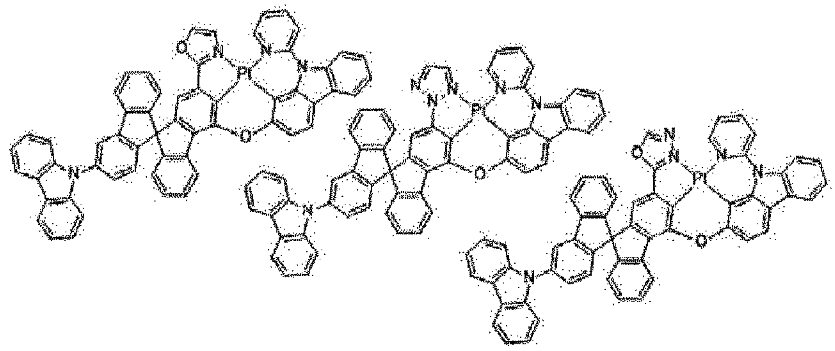

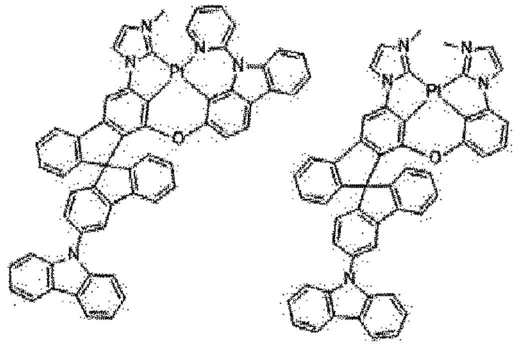

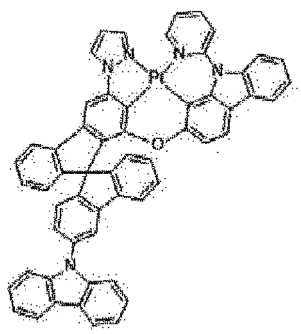

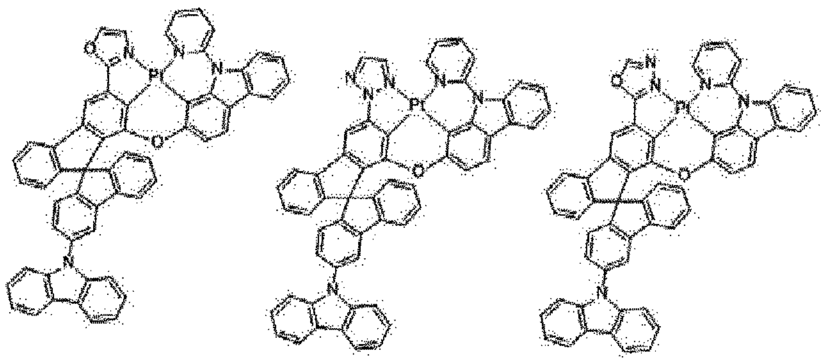

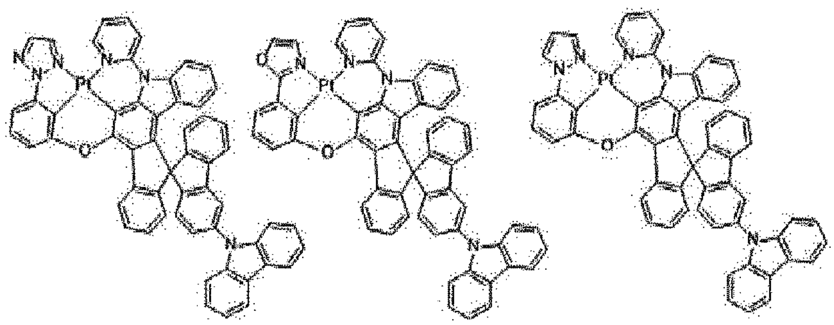

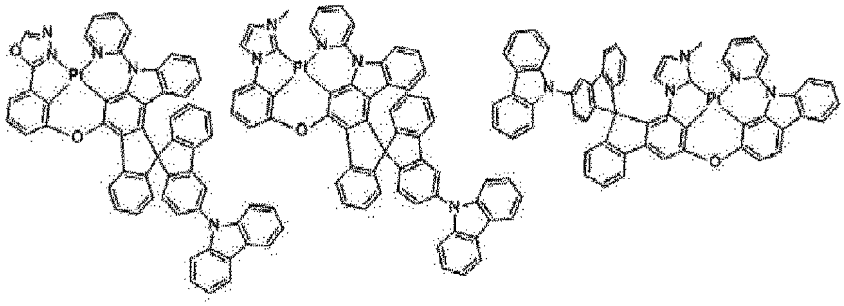

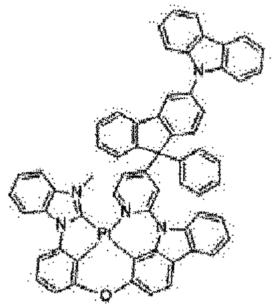

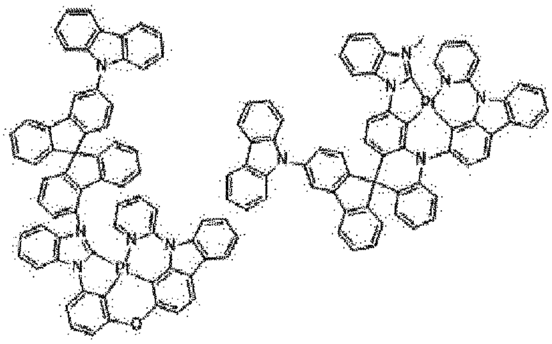

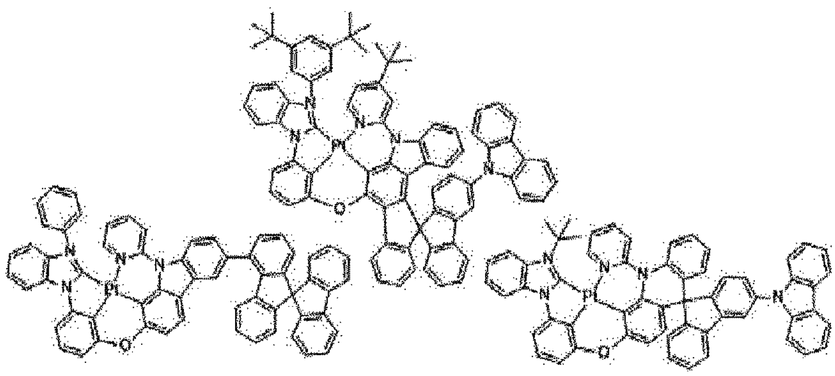

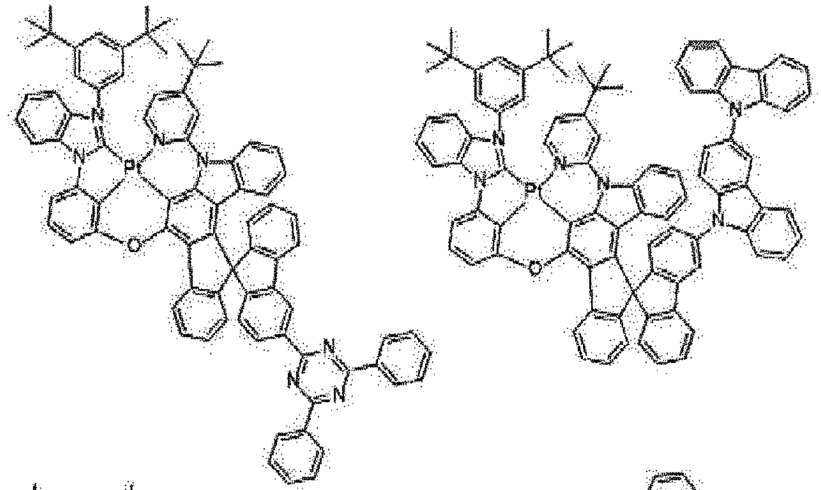

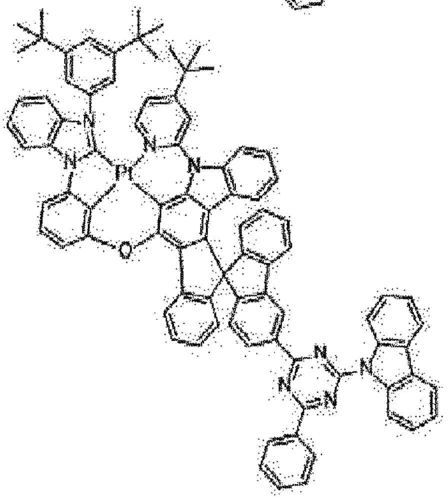

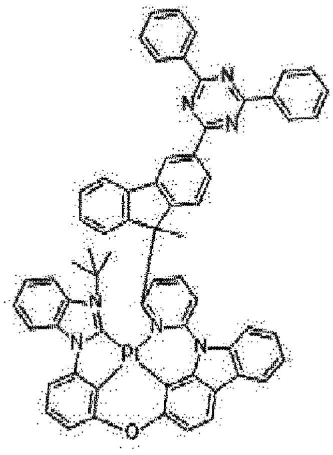

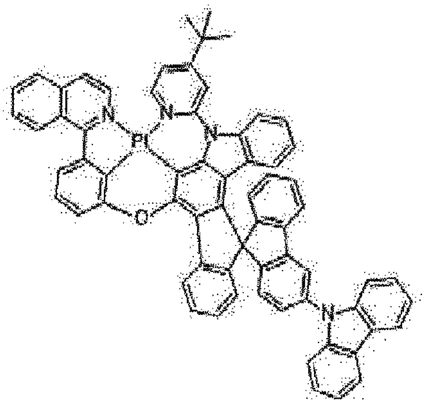

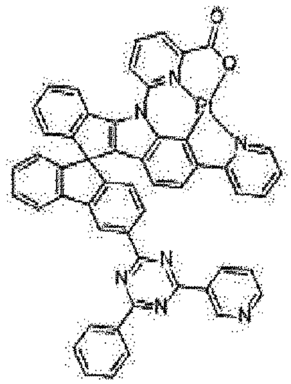

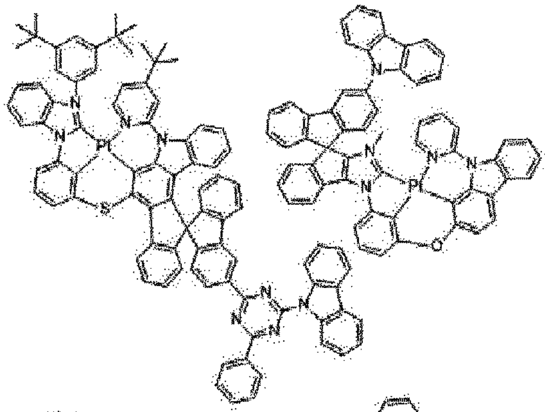

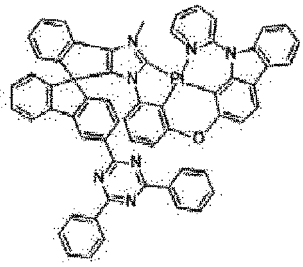

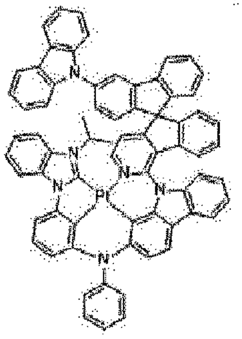

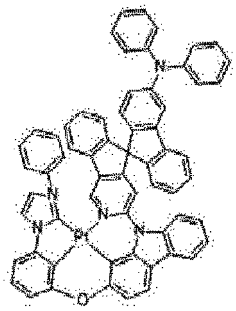

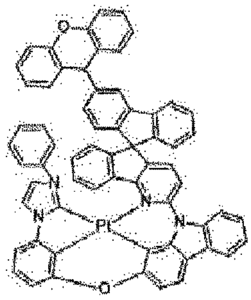

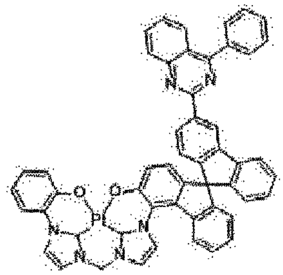

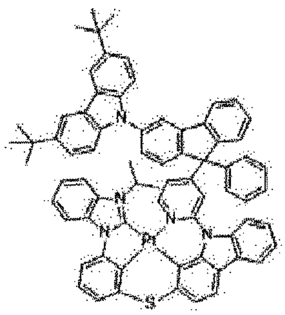

One embodiment of the present invention provides an organic light-emitting diode including:

a first electrode; a second electrode; and a light-emitting layer disposed between the first electrode and the second electrode; and
further including or not including an organic layer adjacent to any one or both surfaces of the light-emitting layer,
in which the light-emitting layer includes the multifunctional compound, and
the light-emitting layer or the adjacent organic layer includes an excited complex-forming compound.

The organic light-emitting diode improves luminous efficiency by using the multifunctional compound capable of increasing a rate constant value related to an energy transfer rate.

The organic light-emitting diode exhibits high quantum efficiency while readily implementing various colors including a deep blue color.

Detailed description on the multifunctional compound included in the organic light-emitting diode is the same as the description stated above.

The organic light-emitting diode may include the multifunctional compound at a level equal to or higher than a common dopant content level. This means that the content of the light-emitting moiety may be the same as or higher than the dopant content level. For example, the content of the multifunctional compound may be the same as or higher than a common dopant content level in order to increase the excited complex-forming ratio between the excited complex-forming moiety of the multifunctional compound and the second excited complex-forming compound. The excited complex-forming moiety of the multifunctional compound is capable of efficiently preventing a concentration quenching phenomenon occurring due to the interaction between the light-emitting moieties, and therefore, it is highly likely that efficiency and color are not significantly affected even when the doping amount of the multifunctional compound increases. The ratio of

the multifunctional compound in the light-emitting layer may be, for example, in a range of, 1 mol% to 50 mol% based on all the materials forming the light-emitting layer, and the ratio may be higher depending on the application.

In one embodiment, the light-emitting layer may include at least two types of the multifunctional compound.

In one embodiment, the multifunctional compound may be used as the excited complex-forming compound.

Specifically, when employing an electron donor moiety as the excited complex-forming moiety and the multifunctional compound obtained by bonding the excited complex-forming moiety to the light-emitting moiety as a first multifunctional compound, and employing an electron acceptor moiety as the excited complex-forming moiety and the multifunctional compound obtained by bonding the excited complex-forming moiety to the light-emitting moiety as a second multifunctional compound, the first multifunctional compound and the second multifunctional compound included in the light-emitting layer have an excited complex formed between each of the electron acceptor moieties and the electron donor moieties, and may have the energy being transferred to the light-emitting moiety. In this case, one that emits light among the first multifunctional compound and the second multifunctional compound corresponds to the multifunctional compound, and the other one corresponds to the excited complex-forming compound.

The ratio of the excited complex-forming compound in the light-emitting layer may be, for example, in a range of 0.1 mol% to 99.9 mol% based on all the materials forming the light-emitting layer, and the ratio may be higher depending on the application.

In one embodiment, the light-emitting layer may further include at least one selected from the group consisting of a host, an additional dopant and combinations thereof.

The host may be a material generally known as a host material capable of forming a light-emitting layer.

The additional dopant may be a material known as a light-emitting material or a material generally known as a dopant doped as a light-emitting material in a light-emitting layer. The additional dopant may perform a role of re-emitting by absorbing emission energy of the light-emitting moiety. Accordingly, the maximum emission wavelength energy of the additional dopant may be smaller than the highest emission wavelength energy of the light-emitting moiety. Emission of low energy may be obtained by using the additional dopant.

The highest emission wavelength energy means a wavelength having the largest photon energy in the emission spectrum. The highest emission wavelength is obtained from an onset value at the position where emission starts, and the maximum emission wavelength is obtained from the wavelength having the highest luminescence intensity.

The organic light-emitting diode may further include a phosphorescent material in the light-emitting layer in order to further increase luminous efficiency of the light-emitting layer.

In one embodiment, the light-emitting layer may further include a phosphorescent material including Pt or Ir.

Compounds represented by the following structural formulae are examples of organometallic complexes commonly used as the phosphorescent material.

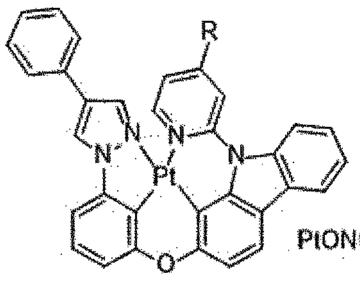
PtON6-tBu

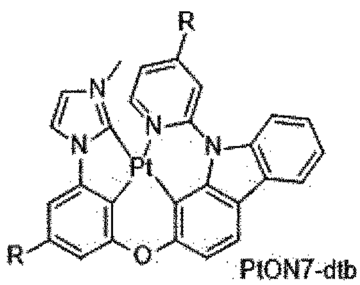
PtON7-dtb

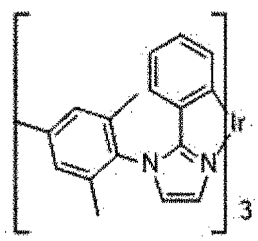

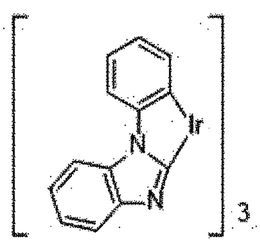

In the formulae, R may be alkyl having 1 to 20 carbon atoms, cycloalkyl having 3 to 20 carbon atoms, heterocycloalkyl having 2 to 20 carbon atoms, aryl having 6 to 30 carbon atoms, and the like.

The organic light-emitting diode may further include a delayed fluorescent material in the light-emitting layer in order to further increase luminous efficiency of the light-emitting layer.

In one embodiment, the light-emitting layer may further include a delayed fluorescent material in which an energy

difference between a singlet and a triplet is 0.3 eV or greater.

Compounds represented by the following structural formulae are examples of the delayed fluorescent material commonly used.

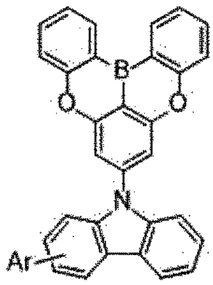

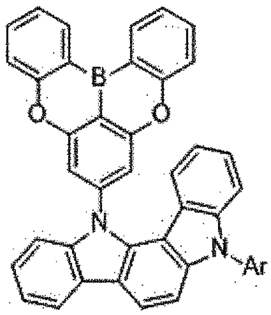

In the formulae, Ar may be alkyl having 1 to 20 carbon atoms, cycloalkyl having 3 to 20 carbon atoms, heterocycloalkyl having 2 to 20 carbon atoms, aryl having 6 to 30 carbon atoms, and the like.

The organic light-emitting diode may include one selected from the group consisting of a hole injection layer, a hole transport layer, an electron blocking layer, a hole blocking layer, an electron transport layer, an electron injection layer and combinations thereof as the organic layer.

In one embodiment, the organic light-emitting diode may sequentially include an anode, a hole injection layer (HIL), a hole transport layer (HTL), a light-emitting layer (EML), an electron transport layer (ETL) and a cathode.

The organic light-emitting diode may form the light-emitting layer including the multifunctional compound by a deposition process or a solution process.

The organic light-emitting diode may be a tandem-type organic light-emitting diode including a plurality of organic light-emitting units. One organic light-emitting unit includes a light-emitting layer, and may further include at least one organic layer. The organic layer may include one selected from the group consisting of a hole injection layer, a hole transport layer, an electron blocking layer, a hole blocking layer, an electron transport layer, an electron injection layer and combinations thereof.

The plurality of organic light-emitting units may be sequentially laminated, and a charge generation layer (CGL) may be included between each of the organic light-emitting units. The charge generation layer is located between the organic light-emitting units so as to smoothly distribute charges to the light-emitting layer of each organic light-emitting unit.

In the tandem-type organic light-emitting diode, at least one organic light-emitting unit includes the light-emitting layer including the multifunctional compound,

an organic layer adjacent to any one or both surfaces of the light-emitting layer including the multifunctional compound may or may not be further included,
the light-emitting layer including the multifunctional compound or the adjacent organic layer includes an excited complex-forming compound,
the multifunctional compound includes an excited complex-forming moiety and a light-emitting moiety,
the excited complex-forming moiety forms an excited complex with the excited complex-forming compound, and
the light-emitting moiety emits light by receiving excited energy of the excited complex.

In the tandem-type organic light-emitting diode, detailed description on the multifunctional compound, the excited complex-forming compound and the like is the same as the description stated above.

The present invention has been described with reference to exemplified drawings as above, however, the present invention is not limited by the embodiments and drawings disclosed in the present specification, and it is obvious that various modifications may be made by those skilled in the art within the scope of technical ideas of the present invention. In addition, even when the working effects obtained by the constitutions of the present invention are not explicitly described while describing the embodiments of the present invention, it is natural that effects predictable by the corresponding constitutions need to be acknowledged as well.

**[Synthesis Example]**

Synthesis of Comparative Compound 1

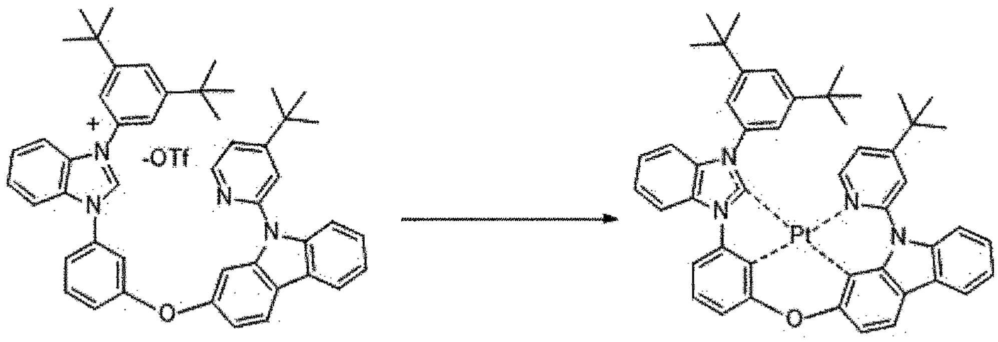

Comparative Compound 1-1 Comparative Compound 1

After dissolving Comparative Compound 1-1 (7.00 g, 8.3 mmol), dichloro(cycloocta-1,5-diene)platinum(II) (3.72 g, 9.9 mmol) and sodium acetate (2.04 g, 24.8 mmol) in 1,4-dioxane (83 ml) under a nitrogen atmosphere, the temperature was raised to 115°C to 120°C, and the mixture was stirred for 16 hours.
The reaction solution was cooled to room temperature, concentrated under reduced pressure, and then extracted with dichloromethane. The organic layer was dried with $MgSO_4$, and then filtered. The filtrate was concentrated under reduced pressure, and then purified using a silica gel column chromatography (DCM/hexane) method.
After that, the result was purified through recrystallization using a mixed solvent of DCM/hexane to obtain Comparative Compound 1 (2.21 g) in a yield of 30%.

MS(ACPI) m/z: 890[M+H]
NMR: δH (500 MHz; $CDCl_3$; $Me_4Si$) 8.71 (d, J=6.3 Hz, 1H), 8.15 (d, J=8.3 Hz, 1H), 7.99-7.98 (m, 1H), 7.82 (d, J=8.3 Hz, 1H), 7.60-7.58 (m, 1H), 7.54 (s, 1H), 7.51-7.47 (m, 3H), 7.43 (d, J=8.38 Hz, 1H), 7.36-7.33 (m, 2H), 7.29-7.26 (m, 4H), 7.09 (d, J=8.1 Hz, 1H), 7.01 (t, J=7.7 Hz, 1H), 5.52 (d, J=3.2 Hz, 1H), 1.50 (br, 9H), 0.99 (br, s. 9H), 0.82 (s, 9H).

Synthesis of Compound 2

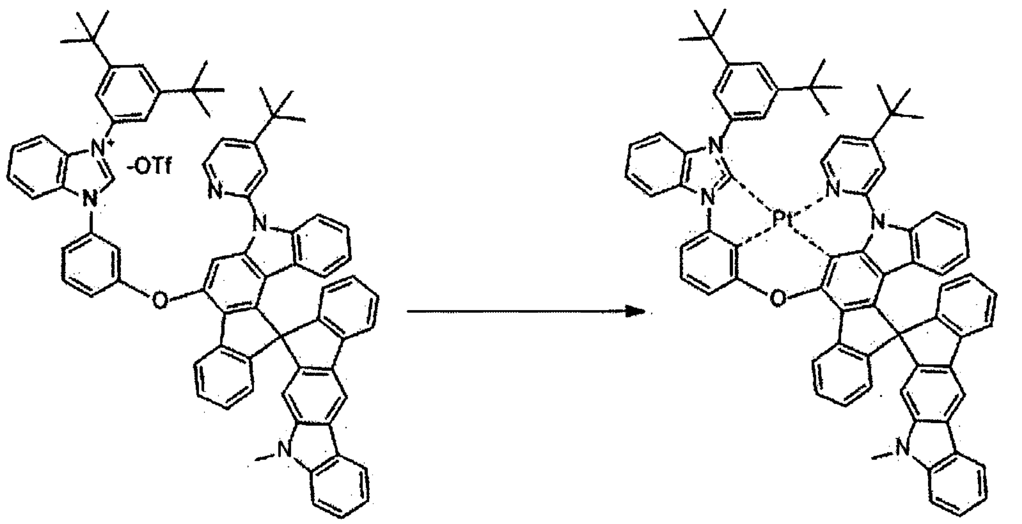

Compound 2-1 Compound 2

Compound 2 was synthesized in the same manner as above (Synthesis of Comparative Compound 1), except that Compound 2-1 was used instead of Comparative Compound 1-1 in the same molar ratio.
After final purification, Compound 2 was obtained (2.04 g) in a yield of 20%.

MS(ACPI) m/z: 1231[M+H]

NMR: δH (500 MHz; $CDCl_3$; $Me_4Si$) 8.95-8.93 (1H, d, J=7.78 Hz), 8.78-8.77 (1H, d, J=5.95 Hz), 8.69 (1H, s), 8.28-8.26 (1H, d, J=8.23 Hz), 8.22-8.20 (1H, d, J=8.23 Hz), 8.12-8.10 (1H, d, J=7.55 Hz), 7.70-7.33 (15H, m), 7.25-7.21 (2H, m), 7.02-6.98 (3H, m), 6.88-6.85 (2H, m), 6.74-6.72 (1H, d, J= 8.00), 6.67-6.63 (2H, d), 3.48 (3H, s), 1.55 (9H, s), 1.01 (18H, br.s).

Synthesis of Compound 3

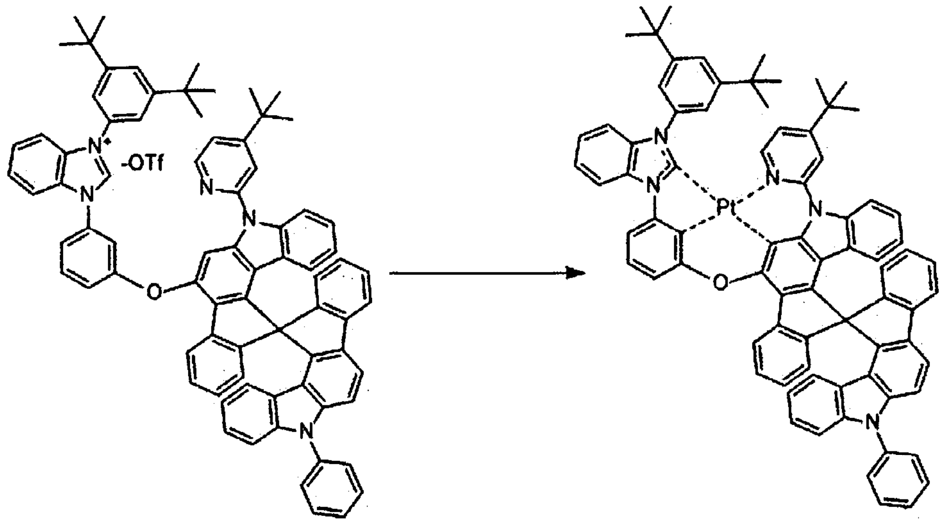

Compound 3-1 Compound 3

Compound 3 was synthesized in the same manner as above (Synthesis of Comparative Compound 1), except that Compound 3-1 was used instead of Comparative Compound 1-1 in the same molar ratio.

After final purification, Compound 3 was obtained (2.46 g) in a yield of 23%.

MS(ACPI) m/z: 1293[M+H]

NMR: δH (500 MHz; $CDCl_3$; $Me_4Si$) 9.06-9.04 (1H, d, J=7.78 Hz), 8.73-8.72 (1H, d, J=6.40 Hz), 8.31-8.29 (1H, d, J=8.46 Hz), 8.13-8.11 (1H, d, J=8.46 Hz), 7.94-7.92 (1H, d, J=7.55 Hz), 7.77-7.73 (2H, d, J=1.83 Hz), 7.66-7.35 (17H, m), 7.30-7.25 (1H, m), 7.15-7.13 (1H, s, J=8.00 Hz), 7.06-6.87 (6H, m), 6.74-6.63 (4H, m), 1.55 (9H, s), 1.09 (18H, s).

Synthesis of Compound 4

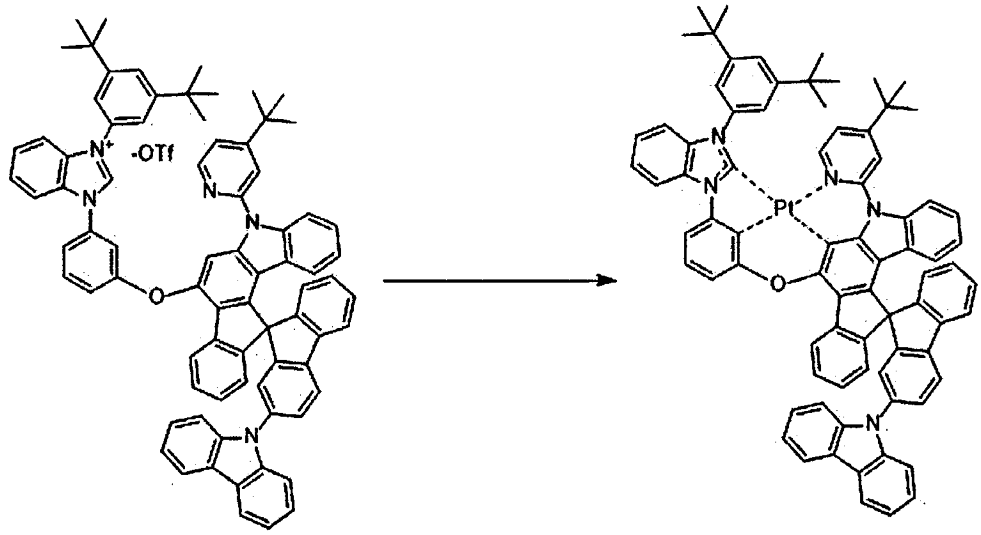

Compound 4-1 Compound 4

Compound 4 was synthesized in the same manner as above (Synthesis of Comparative Compound 1), except that Compound 4-1 was used instead of Comparative Compound 1-1 in the same molar ratio.

After final purification, Compound 4 was obtained (2.67 g) in a yield of 25%.

MS(ACPI) m/z: 1293[M+H]

NMR: δH (500 MHz; $CDCl_3$; $Me_4Si$) 8.95 (1H, br.s), 8.86-8.85 (1H, d, J=6.11 Hz), 8.22-8.21 (1H, d, J=7.95 Hz), 8.16-8.14 (1H, d, J=8.56 Hz), 8.08-8.06 (1H, d, J=7.64 Hz), 7.59-7.36 (9H, m), 7.21-7.00 (14H, m), 6.89-6.87 (2H, d, J=7.34 Hz), 6.78-6.74 (3H, m), 6.65-6.63 (1H, d, J=7.95 Hz), 1.55 (9H, s), 0.98 (18H, s).

**[Device Example]**

An ITO surface was treated with UV ozone for 3 minutes at atmospheric pressure.

In a $10^{-7}$ torr vacuum chamber, processes were performed in the following order to manufacture a device.

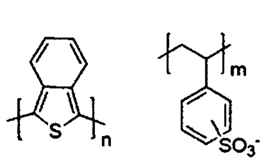

PEDOT:PSS

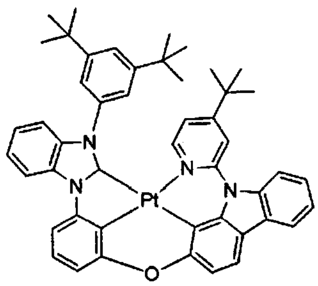

비교 화합물 1

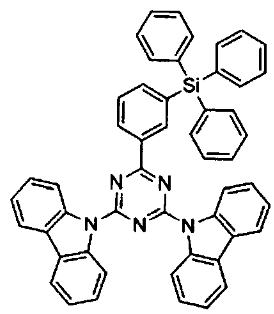

화합물 A

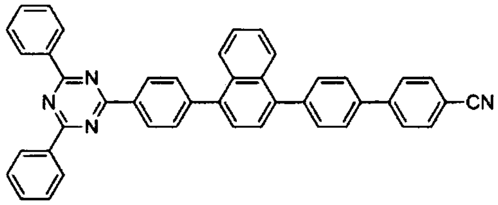

화합물 B

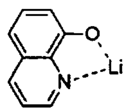

Liq

비교 화합물 1: Comparative Compound

화합물 A: Compound A

화합물 B: Compound B

**Device 1 (Comparative Example 1)**

As a hole injection material, PEDOT:PSS was spin-coated for 1 minute at 4000 rpm, and heated for 10 minutes at 120°C. As a light-emitting layer, Comparative Compound 1 (0.0046 g) and Compound A (0.0154 g) were dissolved in toluene (2 ml), and the mixture was spin-coated for 1 minute at 1000 rpm and then heated for 10 minutes at 60°C under vacuum. As an electron transport layer, Compound B and LiQ were deposited in a ratio of 1:1 to a thickness of 300 Å. As an electrode, Al was deposited to a thickness of 1000 Å.

**Device 2 (Example 1)**

Device 2 was manufactured in the same manner as in Device 1, except that the light-emitting layer of Device 1 was doped with 20 mol% of Compound 2.

The doping mol% representing maximum luminous efficiency in each device was measured below under a condition of 10 $mA/cm^2$.

[Table 1]

| Device (10 $mA/cm^2$) | | Dopant | Doping mol% | Voltag e (V) | EQE (%) | CIE x | CIE y | λmax |
|---|---|---|---|---|---|---|---|---|
| Compa rativ e | Devi ce 1 | Comparat ive | 20 | 7.68 | 5.42 | 0.184 | 0.240 | 456 |
| Examp le 1 | | Compound 1 | | | | | | |
| Examp le 1 | Devi ce 2 | Compound 2 | 20 | 4.93 | 8.12 | 0.158 | 0.169 | 456 |

As may be identified in Table 1, the device of the present invention shows high efficiency properties. Compound 2 forms an exciplex with Compound A to transfer energy to the light-emitting unit, resulting in an increase in luminous efficiency. The exciplex-forming unit of Compound 2 shows excellent properties in color coordinates as well by preventing concentration interactions between the dopants. In addition, a low driving voltage is exhibited at the same current density, and this may be explained by the fact that the exciplex-forming unit of Compound 2 helps with hole injection. It was identified that excellent device properties were able to be obtained by combining the light-emitting unit and the exciplex-forming unit as above.

Hereinbefore, the present invention has been described with reference to accompanying drawigs, however, the present invention is not limited by the embodiments and the drawings disclosed in the present specification, and it is obvious that various modifications may be made by those skilled in the art within the scope of technical ideas of the present invention. In addition, even when working effects obtained from the constitutions of the present invention are not explicitly described while describing the embodiments of the present invention, it is logical that effects predictable by the corresponding constitutions need to be acknowledged as well.

## Claims

**1.** A multifunctional compound represented by the following Chemical Formula 1:

<Chemical Formula 1>

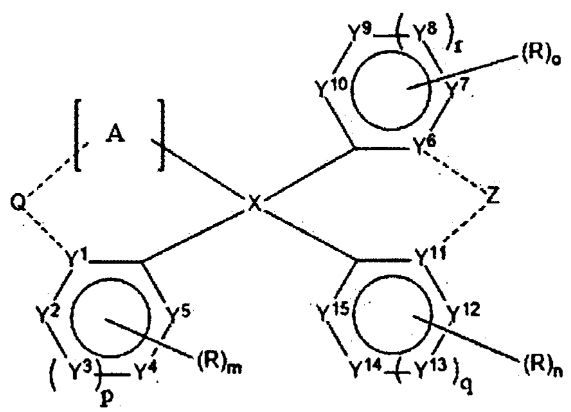

wherein, in Chemical Formula 1,

A is a structure represented by the following Chemical Formula 2, and is linked through a first linking position of A, or linked through a first linking position and a second linking position of A;

X is C, Si, Ge, Sn or Pb, and the first linking position of A is linked to X;

Q is not present, or a single bond, -B($Ar^1$)-,-C($Ar^1$)($Ar^2$)-, -Si($Ar^1$)($Ar^2$)-, -Ge($Ar^1$)($Ar^2$)-, -N($Ar^1$)-,-P($Ar^1$)-, -PO($Ar^1$)-, -O-, -S-, -SO-, -$SO_2$-, -Se-, -SeO-, -$SeO_2$-, -CO-, -CS- or -CSe-, and herein, $Ar^1$ and $Ar^2$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^1$ and $Ar^2$ are optionally linked to each other to form a ring, or each optionally linked to $Y^2$, R that is linked to $Y^2$, or A to form a fused ring;

when Q is not present, A is not directly linked to $Y^1$ at the second linking position of A;

when Q is a single bond, A is linked to $Y^1$ by a single bond at the second linking position of A;

when Q is not a single bond and is present as any one defined as above, A is linked to Q at the second linking position of A;

when Q is not a single bond and is present as any one defined as above, Q is linked to A and $Y^1$ each by a single bond;

$Y^1$ to $Y^{15}$ are each independently boron, carbon, nitrogen, oxygen, sulfur, Se or Te;

Z is not present, or a single bond, -B($Ar^3$)-,-C($Ar^3$)($Ar^4$)-, -Si($Ar^3$)($Ar^4$)-, -Ge($Ar^3$)($Ar^4$)-, -N($Ar^3$)-,-P($Ar^4$)-, -PO($Ar^3$)-, -O-, -S-, -SO-, -$SO_2$-, -Se-, -SeO-, -$SeO_2$-, -CO-, -CS- or -CSe-, and herein, $Ar^3$ and $Ar^4$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^3$ and $Ar^4$ are optionally linked to each other to form a ring, or each optionally linked to any one of $Y^7$, $Y^{12}$, R that is linked to $Y^7$ or R that is linked to $Y^{12}$ to form a fused ring;

when Z is not present, $Y^6$ and $Y^{11}$ are not directly linked;

when Z is a single bond, $Y^6$ and $Y^{11}$ are linked by a single bond;

when Z is not a single bond and is present as any one defined as above, Z is linked to $Y^6$ and $Y^{11}$ each by a single bond;

m, n and o are each independently an integer of 0 to 5;

Rs are each independently at least one selected from the group consisting of hydrogen, deuterium, halogen, cyano, -$NO_2$, alkyl having 1 to 30 carbon atoms unsubstituted or substituted with an additional substituent, alkenyl

having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent,

allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{101})(R^{102})$, $-C(R^{103})(R^{104})(R^{105})$, $-Si(R^{106})(R^{107})(R^{108})$, $-Ge(R^{109})(R^{110})(R^{111})$, $-N(R^{112})(R^{113})$, $-P(R^{114})(R^{115})$, $-PO(R^{116})(R^{117})$, $-O(R^{118})$, $-S(R^{119})$, $-SO(R^{120})$, $-SO_2(R^{121})$, $Se(R^{122})$, $-SeO(R^{123})$, $-SeO_2(R^{124})$ and combinations thereof;

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom are optionally linked to form a ring;

at least two Rs present when m, n or o is 2 or greater are optionally linked to each other to form a ring;

p, q and r each independently represent 0 or 1, and when p, q or r is 0, it means that a 5-membered ring is formed, and when p, q or r is 1, it means that a 6-membered ring is formed;

however, at least one atom of $Y^6$ to $Y^{15}$ and Z is an atom including an unshared electron pair, or R bonding thereto includes at least one atom including an unshared electron pair,

<Chemical Formula 2>

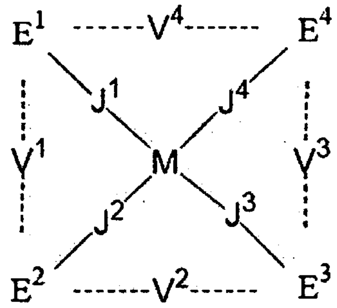

in Chemical Formula 2,

M is a transition metal;

$V^1$, $V^2$, $V^3$ and $V^4$ are each independently not present, or a single bond, $-B(Ar^5)-$, $-C(Ar^5)(Ar^6)-$, $-Si(Ar^5)(Ar^6)-$, $-Ge(Ar^5)(Ar^6)-$, $-N(Ar^5)-$, $-P(Ar^5)-$, $-PO(Ar^5)-$, -O-, -S-, -SO-, $-SO_2-$, -Se-, -SeO-, $-SeO_2-$, -CO-, -CS- or -CSe-, and herein, $Ar^5$ and $Ar^6$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^5$ and $Ar^6$ are optionally linked to each other to form a ring, or each optionally linked to adjacent $E^1$, $E^2$, $E^3$ or $E^4$ to form a fused ring;

however, at least one of $V^1$, $V^2$, $V^3$ and $V^4$ is a single bond;

when $V^1$, $V^2$, $V^3$ and $V^4$ are not present, two of the adjacent $E^1$, $E^2$, $E^3$ and $E^4$ are not directly linked;

when $V^1$, $V^2$, $V^3$ and $V^4$ are a single bond, two of the adjacent $E^1$, $E^2$, $E^3$ and $E^4$ are directly linked by a single bond,

and when $V^1$, $V^2$, $V^3$ and $V^4$ are not a single bond and are present as any one defined as above, they are linked to two of the adjacent $E^1$, $E^2$, $E^3$ and $E^4$ each by a single bond, or two bonds linked to two of the adjacent $E^1$, $E^2$, $E^3$ and $E^4$ optionally form a conjugated structure together;

$J^1$, $J^2$, $J^3$ and $J^4$ are each a single bond, O or S;

when $J^1$, $J^2$, $J^3$ and $J^4$ are a single bond, any one of $E^1$, $E^2$, $E^3$ and $E^4$ linked thereto directly bonds to M by a coordination bond or a covalent bond;

when $J^1$, $J^2$, $J^3$ and $J^4$ are O or S, the bond with M is a coordination bond or a covalent bond;

$E^1$, $E^2$, $E^3$ and $E^4$ are each independently a monovalent, divalent or trivalent group and defined as below, provided that, when $E^1$, $E^2$, $E^3$ and $E^4$ are a monovalent group, the adjacent two of $V^1$, $V^2$, $V^3$ and $V^4$ are both absent; when $E^1$, $E^2$, $E^3$ and $E^4$ are a divalent group, any one of the adjacent two of $V^1$, $V^2$, $V^3$ and $V^4$ is not present; and when $E^1$, $E^2$, $E^3$ and $E^4$ are a trivalent group, the adjacent two of $V^1$, $V^2$, $V^3$ and $V^4$ are both present;

$E^1$, $E^2$, $E^3$ and $E^4$ are each independently a monovalent group of halogen or cyano, or saturated or unsaturated aliphatic hydrocarbon having 1 to 50 carbon atoms unsubstituted or substituted with an additional substituent; saturated or unsaturated heteroatom-containing aliphatic hydrocarbon having 1 to 50 carbon atoms unsubstituted or substituted with an additional substituent; an aromatic carbon ring having 5 to 50 carbon atoms unsubstituted or substituted with an additional substituent; an aromatic heteroring having 2 to 50 carbon atoms unsubstituted or substituted with an additional substituent; a saturated or unsaturated alicyclic carbon ring having 3 to 50 carbon atoms unsubstituted or substituted with an additional substituent; or a saturated or unsaturated alicyclic heteroring having 2 to 50 carbon atoms unsubstituted or substituted with an additional substituent;

at least two additional substituents included in $E^1$, $E^2$, $E^3$ and $E^4$ are optionally linked to form a ring;

however, when $J^1$, $J^2$, $J^3$ or $J^4$ is a single bond, the atom at the linking position from the adjacent $E^1$, $E^2$, $E^3$ or $E^4$ to M is carbon, nitrogen, oxygen, sulfur or phosphorous; or when $J^1$, $J^2$, $J^3$ or $J^4$ is O or S, the atom at the linking position from the adjacent $E^1$, $E^2$, $E^3$ or $E^4$ to O or S of $J^1$, $J^2$, $J^3$ or $J^4$ is carbon;

in any one of $E^1$, $E^2$, $E^3$ and $E^4$, the linking position to the adjacent $J^1$, $J^2$, $J^3$ or $J^4$ and the linking position to the adjacent $V^1$, $V^2$, $V^3$ or $V^4$ are adjacent to each other;

in any one of $E^1$, $E^2$, $E^3$ and $E^4$, the linking positions to two of the adjacent $V^1$, $V^2$, $V^3$ and $V^4$ are different from each other;

an atom capable of bonding according to a stoichiometric ratio except for M in Chemical Formula 2 is optionally the first linking position or the second linking position of A in Chemical Formula 1, provided that, the first linking position and the second linking position are each (i) different from the linking position from any one of $E^1$, $E^2$, $E^3$ and $E^4$ to the adjacent $J^1$, $J^2$, $J^3$, $J^4$, $V^1$, $V^2$, $V^3$ or $V^4$, and (ii) different from the linking position from any one of $V^1$, $V^2$, $V^3$ and $V^4$ to the adjacent $E^1$, $E^2$, $E^3$ or $E^4$;

the first linking position and the second linking position are adjacent to each other; and

the additional substituents are present in numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms.

**2.** The multifunctional compound of claim 1, wherein M is Rh, Ir, Pd, Pt, Ni, Rh, Co or Au.

**3.** The multifunctional compound of claim 1, wherein Chemical Formula 1 is any one of chemical formulae represented by the following B-1 to B-28:

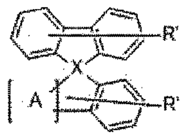
B-1

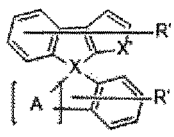
B-2

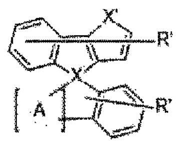
B-3

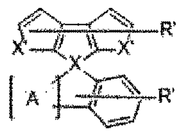
B-4

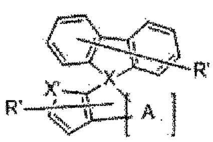
B-5

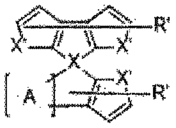
B-6

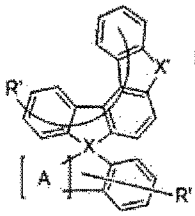
B-7

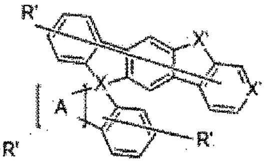
B-8

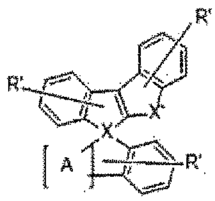
B-9

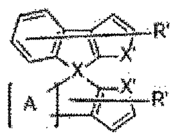
B-10

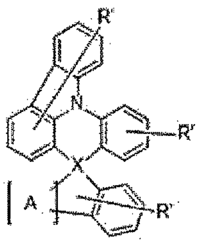
B-11

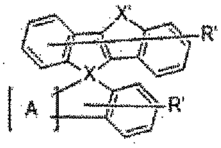
B-12

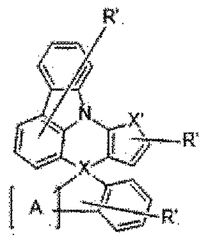
B-13

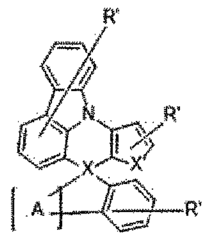
B-14

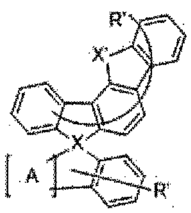
B-15

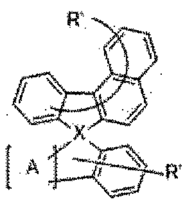
B-16

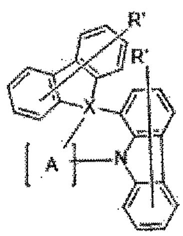
B-17

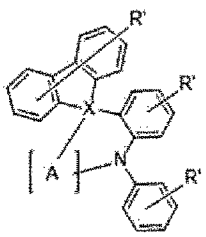
B-18

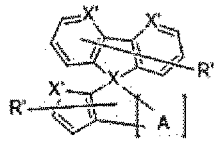
B-19

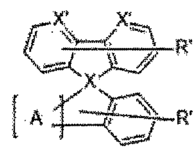
B-20

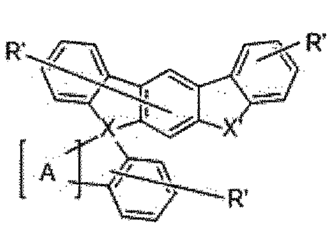
B-21

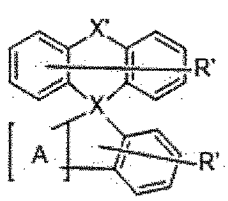
B-22

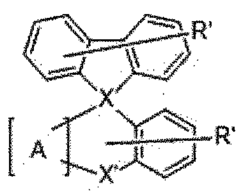
B-23

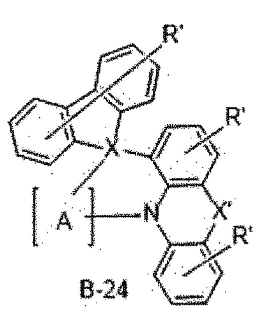
B-24

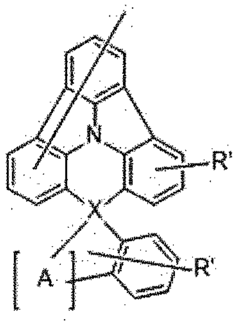
B-25

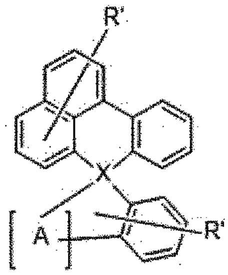
B-26

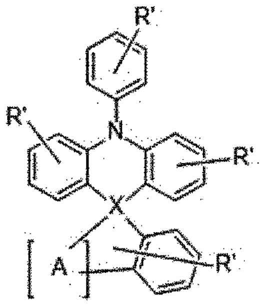
B-27

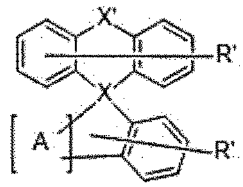
B-28

in B-1 to B-28,

A and X have the same definitions as in Chemical Formula 1;
X's linked by =X'- are each independently =C($Ar^7$)-, =Nor =B-;
X's linked by -X'- are each independently -O-, -S-, - Se-, -C($Ar^7$)($Ar^8$) -, -Si($Ar^7$)($Ar^8$) or -N($Ar^7$)-;
$Ar^7$ and $Ar^8$ in the definition of X' are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^7$ and $Ar^8$ are optionally linked to each other to form a ring, or each optionally linked to an adjacent ring to form a fused ring;
R's are present in numbers capable of bonding according to a stoichiometric ratio, and are each independently at least one selected from the group consisting of hydrogen, deuterium, halogen, cyano, -$NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, -B($R^{101}$)($R^{102}$), -C($R^{103}$)($R^{104}$)($R^{105}$), - Si($R^{106}$)($R^{107}$)($R^{108}$), -Ge($R^{109}$)($R^{110}$)($R^{111}$), -N($R^{112}$)($R^{113}$), - P($R^{114}$)($R^{115}$) , -PO($R^{116}$)($R^{117}$), -O($R^{118}$), -S($R^{119}$), -SO($R^{120}$), - $SO_2$ ($R^{121}$), Se($R^{122}$), -SeO($R^{123}$), -$SeO_2$($R^{124}$) and combinations thereof;
$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom are optionally linked to form a ring; and
the additional substituent has the same definition as in Chemical Formula 1.

**4.** The multifunctional compound of claim 1, wherein A is represented by the following Chemical Formula 3:

<Chemical Formula 3>

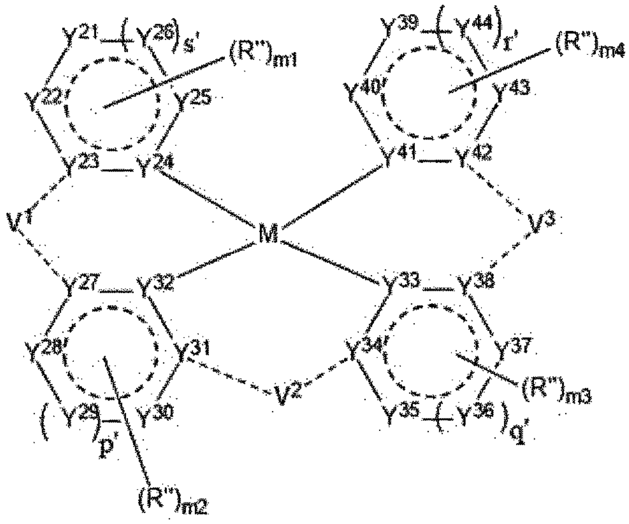

in Chemical Formula 3,

M is Pt;
$V^1$, $V^2$ and $V^3$ have the same definitions as in Chemical Formula 2;
s', p', q' and r' are each 0 or 1;
m1, m2, m3 and m4 are each an integer of 1 to 5;
$Y^{21}$ to $Y^{44}$ are each independently B, N, C, O, P, Si, S, Ge or Se, and the ring including a circle marked by a dotted line optionally does not have a conjugated structure, or partially or fully has a conjugated structure;
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$, - $C(R^{303})(R^{304})(R^{305})$, $-Si(R^{306})(R^{307})(R^{308})$, $-Ge(R^{309})(R^{310})(R^{311})$, - $N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof;
$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom are optionally linked to form a ring; and
the additional substituent has the same definition as in Chemical Formula 1.

**5.** The multifunctional compound of claim 1, wherein A is represented by any one of the following Chemical Formula 4 to Chemical Formula 8:

<Chemical Formula 4>

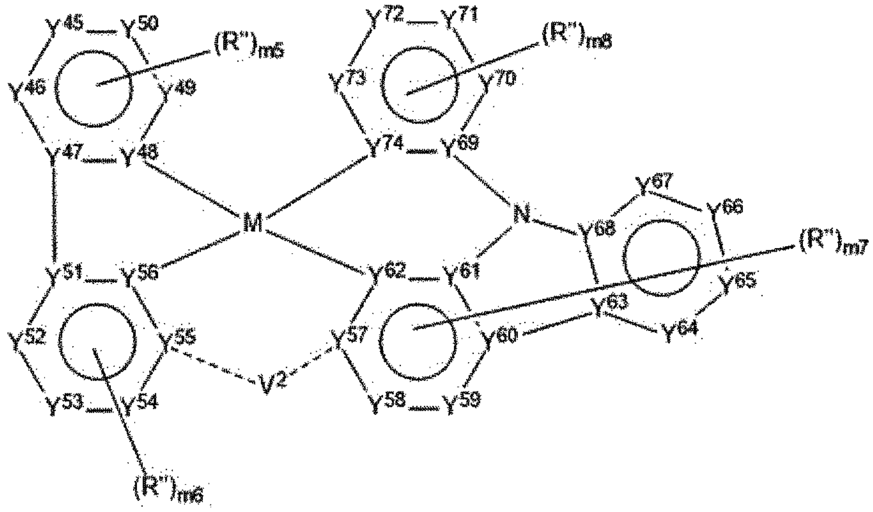

<Chemical Formula 5>

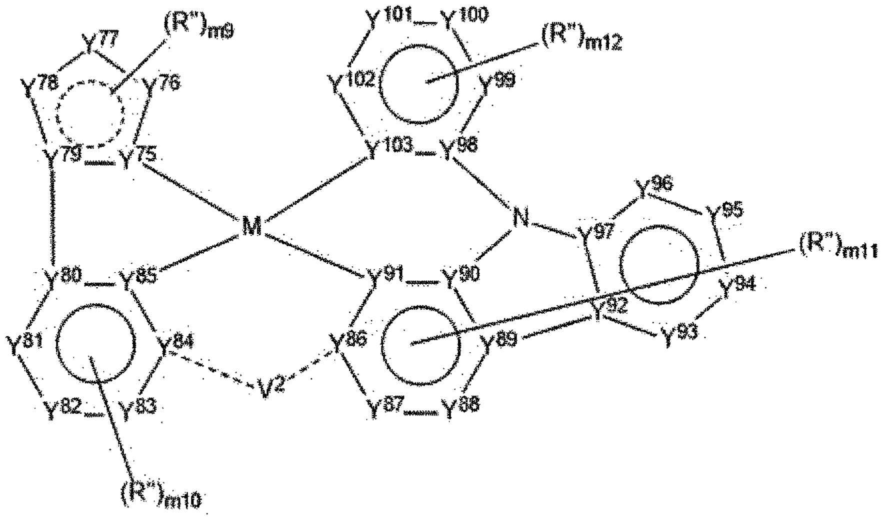

<Chemical Formula 6>

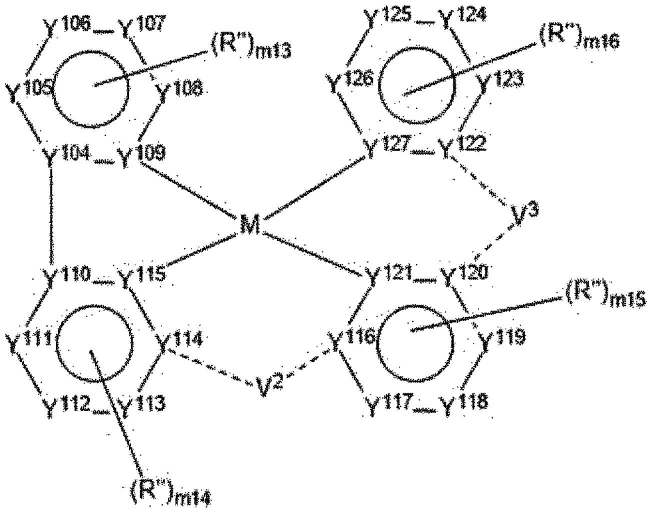

<Chemical Formula 7>

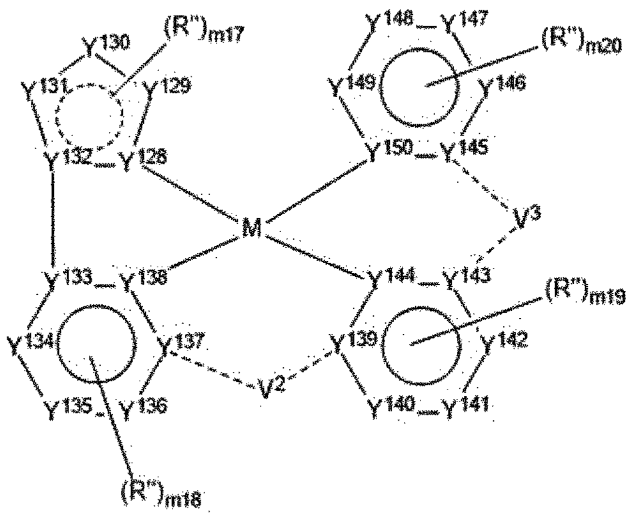

<Chemical Formula 8>

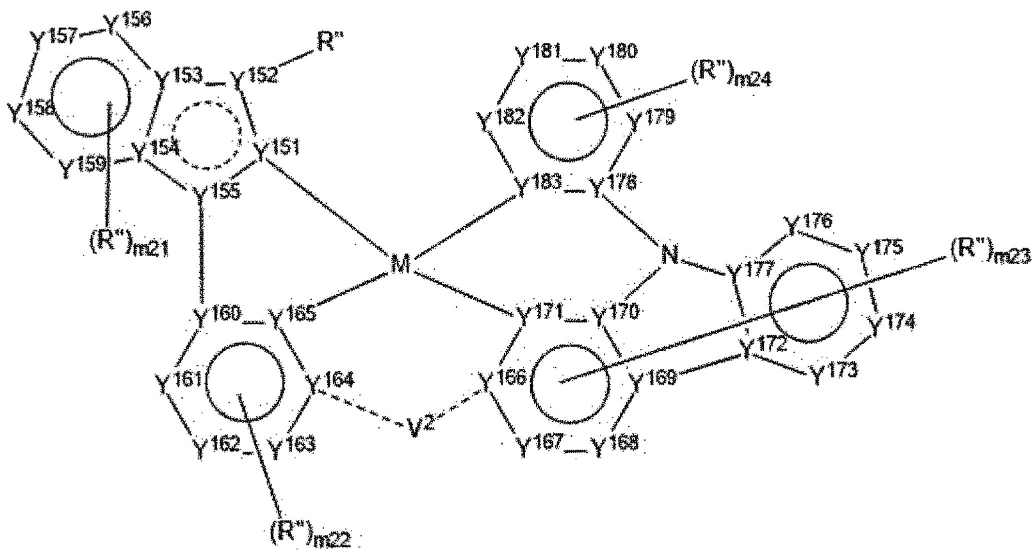

in Chemical Formula 4 to Chemical Formula 8,

M is Pt;

$V^2$ and $V^3$ are each independently not present, or a single bond, -B($Ar^5$)-, -N($Ar^5$)-, -O-, -S- or -Se-, and $Ar^5$s are each independently aryl having 6 to 30 carbon atoms unsubstituted or substituted with an additional substituent, heteroaryl having 2 to 30 carbon atoms unsubstituted or substituted with an additional substituent, alkyl having 1 to 30 carbon atoms unsubstituted or substituted with an additional substituent, cycloalkyl having 3 to 30 carbon atoms unsubstituted or substituted with an additional substituent, heterocycloalkyl having 2 to 30 carbon atoms unsubstituted or substituted with an additional substituent, cycloalkenyl having 3 to 30 carbon atoms unsubstituted or substituted with an additional substituent, or heterocycloalkenyl having 2 to 30 carbon atoms unsubstituted or substituted with an additional substituent;

m5, m6, m8, m10, m12, m13, m14, m18, m21, m22 and m24 are each an integer of 1 to 4;

m15, m16, m19 and m20 are each an integer of 1 to 5;

m7, m11 and m23 are each an integer of 1 to 7;

m9 and m17 are each an integer of 1 to 3;

$Y^{45}$ to $Y^{74}$, $Y^{80}$ to $Y^{127}$, $Y^{133}$ to $Y^{150}$, and $Y^{156}$ to $Y^{183}$ are each independently B, N or C;

$Y^{75}$ to $Y^{79}$, $Y^{128}$ to $Y^{132}$, and $Y^{151}$ to $Y^{155}$ are each independently B, N, C, O, S, Se, Te, Si, Ge or Sn;

the ring including a circle marked by a dotted line in Chemical Formula 5, Chemical Formula 7 and Chemical

Formula 8 optionally does not have a conjugated structure, or partially or fully has a conjugated structure;

R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$, $-C(R^{303})(R^{304})(R^{305})$, $-Si(R^{306})(R^{307})(R^{308})$, $-Ge(R^{309})(R^{310})(R^{311})$, $-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof;

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom are optionally linked to form a ring; and

the additional substituent has the same definition as in Chemical Formula 1.

**6.** The multifunctional compound of claim 1, wherein A is represented by any one of the following Structural Formulae A-1 to A-27:

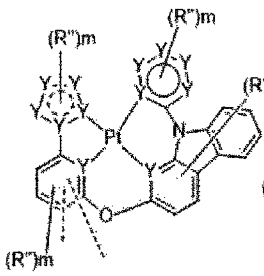

A-1

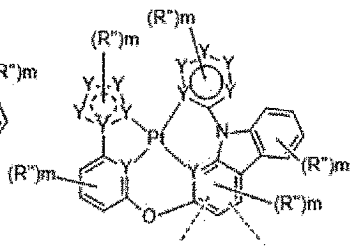

A-2

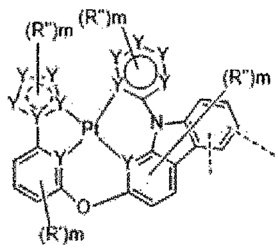

A-3

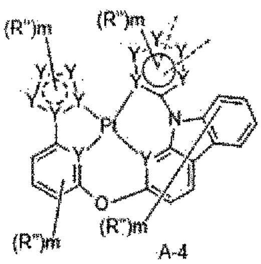

A-4

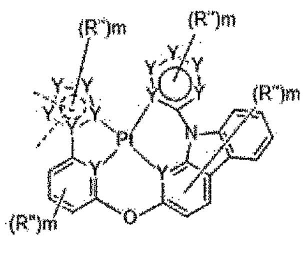

A-5

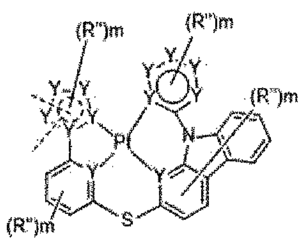

A-6

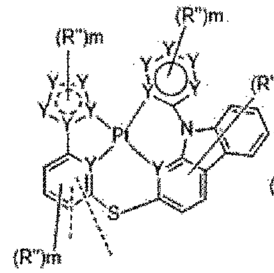

A-7

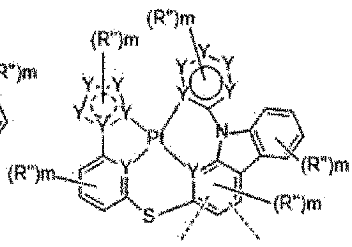

A-8

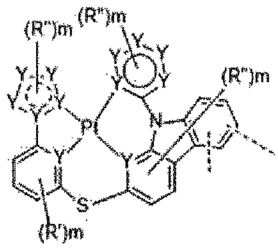

A-9

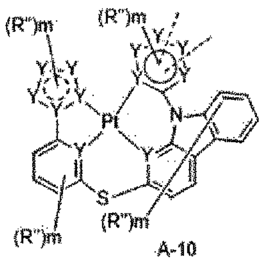

A-10

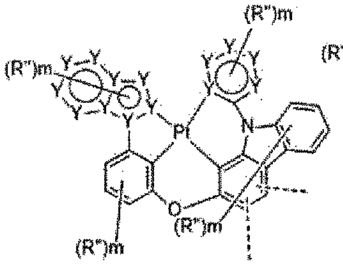

A-11

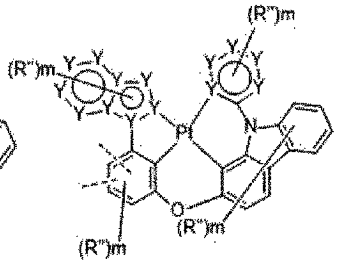

A-12

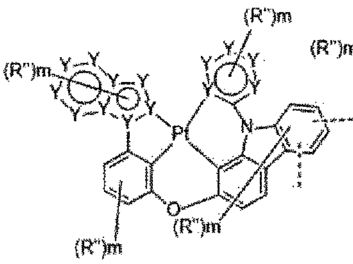

A-13

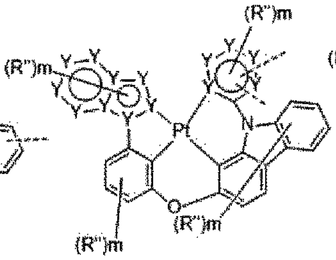

A-14

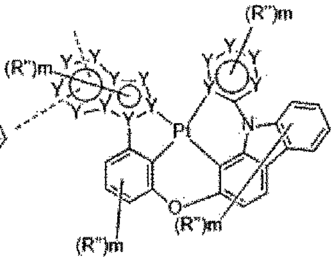

A-15

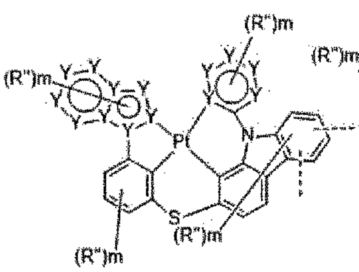

A-13

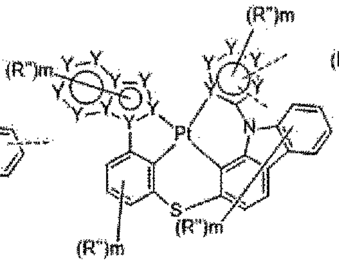

A-14

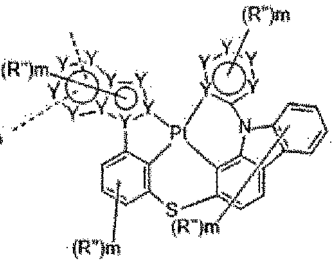

A-15

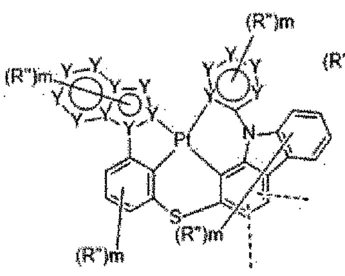

A-16

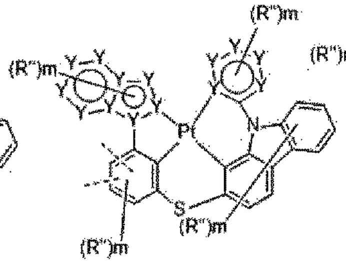

A-17

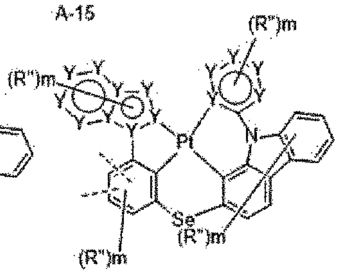

A-18

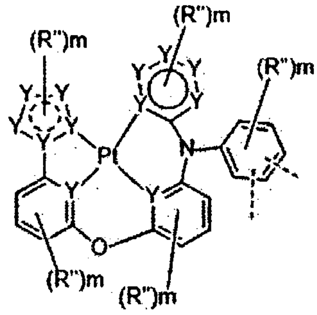

A-19

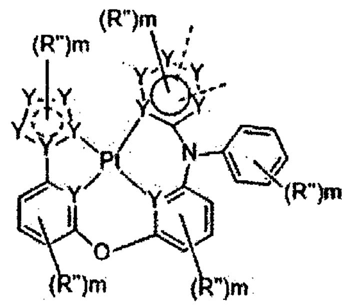

A-20

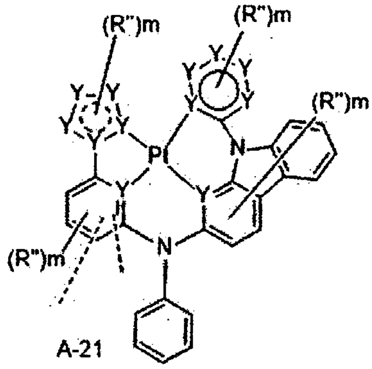

A-21

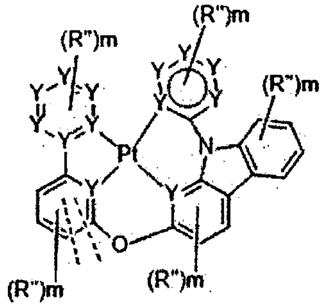

A-22

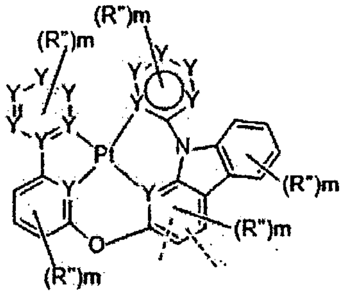

A-23

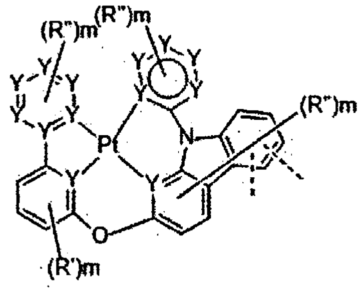

A-24

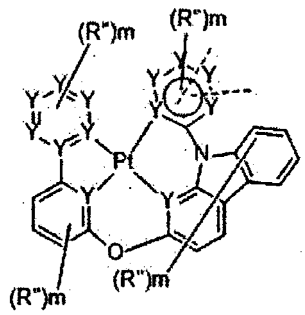

A-25

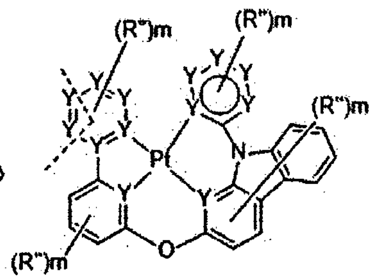

A-26

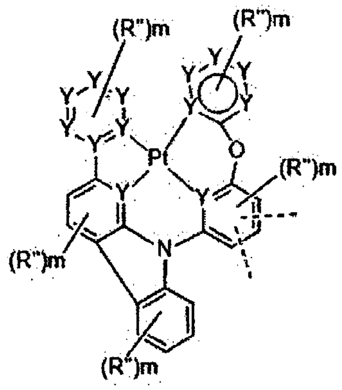

A-27

in A-1 to A-27,

Ys are each independently B, N, C, O, P, Si, S, Ge or Se;
m is an integer of 0 to a maximum number capable of having according to a stoichiometric ratio;
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$, $-C(R^{303})(R^{304})(R^{305})$, $-Si(R^{306})(R^{307})(R^{308})$, $-Ge(R^{309})(R^{310})(R^{311})$, $-N(R^{312})(R^{313})$, $-P(R^{314})(R^{315})$,

-PO($R^{316}$)($R^{317}$), -O($R^{318}$), -S($R^{319}$), -SO($R^{320}$), -$SO_2$($R^{321}$), Se($R^{322}$), -SeO($R^{323}$), -$SeO_2$($R^{324}$) and combinations thereof;

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom are optionally linked to form a ring; and

the additional substituent has the same definition as in Chemical Formula 1.

**7.** The multifunctional compound of claim 1, wherein the multifunctional compound represented by Chemical Formula 1 is divided into an atom represented by X, a light-emitting moiety and an excited complex-forming moiety, the light-emitting moiety and the excited complex-forming moiety are linked through the atom represented by X, and the atom represented by X is X presented in Chemical Formula 1;

the light-emitting moiety includes A, a conjugated ring formed to include $Y^1$ to $Y^5$, and Q in Chemical Formula 1;

the excited complex-forming moiety includes a conjugated ring formed to include $Y^6$ to $Y^{10}$, a conjugated ring formed to include $Y^{11}$ to $Y^{15}$, and Z in Chemical Formula 1; and

the excited complex-forming moiety includes at least one atom having an unshared electron pair included in a wave function of HOMO or LUMO of the excited complex-forming moiety.

**8.** The multifunctional compound of claim 7, wherein at least one of $Y^6$ to $Y^{15}$; and atoms of Z linked to $Y^6$ and $Y^{11}$ is an atom having an unshared electron pair included in a wave function of HOMO or LUMO of the excited complex-forming moiety; or

at least one of $Y^6$ to $Y^{15}$ has R represented by the following Chemical Formula 9 or the following Chemical Formula 10:

<Chemical Formula 9>

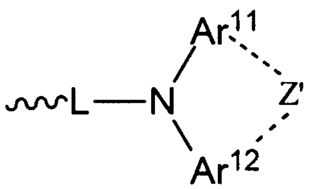

<Chemical Formula 10>

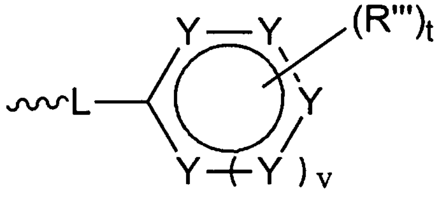

in Chemical Formula 9 and Chemical Formula 10,

L is a single bond, or a divalent group selected from the group consisting of alkylene having 1 to 20 carbon atoms, cycloalkylene having 3 to 20 carbon atoms, cycloalkenylene having 3 to 20 carbon atoms, heteroalkylene having 1 to 20 carbon atoms, heterocycloalkylene having 2 to 20 carbon atoms, heterocycloalkenylene having 2 to 20 carbon atoms, alkenylene having 2 to 20 carbon atoms, -O-, -S-, -P($R^{401}$)-, -PO($R^{402}$)-, arylene having 6 to 20 carbon atoms, heteroarylene having 5 to 20 carbon atoms and combinations thereof;

$Ar^{11}$ and $Ar^{12}$ are each independently a monovalent group or a divalent group of saturated or unsaturated aliphatic hydrocarbon having 1 to 20 carbon atoms unsubstituted or substituted with an additional substituent; saturated or

unsaturated heteroatom-containing aliphatic hydrocarbon having 1 to 20 carbon atoms unsubstituted or substituted with an additional substituent; an aromatic carbon ring having 5 to 20 carbon atoms unsubstituted or substituted with an additional substituent; an aromatic heteroring having 2 to 20 carbon atoms unsubstituted or substituted with an additional substituent; a saturated or unsaturated alicyclic carbon ring having 3 to 20 carbon atoms unsubstituted or substituted with an additional substituent; or a saturated or unsaturated alicyclic heteroring having 2 to 20 carbon atoms unsubstituted or substituted with an additional substituent;

Z' is not present, or a single bond, -B($Ar^{13}$)-, - C($Ar^{13}$)($Ar^{14}$)-, -Si($Ar^{13}$)($Ar^{14}$)-, -Ge($Ar^{13}$)($Ar^{14}$)-, -N($Ar^{13}$)-, - P($Ar^{13}$)-, -PO($Ar^{13}$)-, -O-, -S-, -SO-, -$SO_2$-, -Se-, -SeO-, - $SeO_2$-, -CO-, -CS- or -CSe-, and herein, $Ar^{13}$ and $Ar^{14}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent or heteroaryl having 2 to 30 carbon atoms unsubstituted or substituted with an additional substituent, and $Ar^{13}$ and $Ar^{14}$ are optionally linked to each other to form a ring, or each optionally linked to any one of $Ar^{11}$ and $Ar^{12}$ to form a fused ring;

when Z' is not present, $Ar^{11}$ and $Ar^{12}$ are not directly linked;

when Z' is a single bond, $Ar^{11}$ and $Ar^{12}$ are linked by a single bond;

t is an integer of 0 to 5;

v is 0 or 1;

R'''s are each independently at least one selected from the group consisting of hydrogen, deuterium, halogen, cyano, -$NO_2$, alkyl having 1 to 30 carbon atoms, heteroalkyl having 1 to 30 carbon atoms, cycloalkyl having 3 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, -B($R^{501}$)($R^{502}$), -C($R^{503}$)($R^{504}$)($R^{505}$), - Si($R^{506}$)($R^{507}$)($R^{508}$), -Ge($R^{509}$)($R^{510}$)($R^{511}$), -N($R^{512}$)($R^{513}$), - P($R^{514}$)($R^{515}$), -PO($R^{516}$) ($R^{517}$), -O($R^{518}$), -S($R^{519}$), -SO($R^{520}$), - $SO_2$($R^{521}$), Se($R^{522}$), -SeO($R^{523}$), -$SeO_2$($R^{524}$) and combinations thereof, and herein, at least two R'''s are optionally linked to each other to form a ring;

$R^{401}$ to $R^{402}$ and $R^{501}$ to $R^{524}$ are each independently hydrogen, deuterium, halogen, alkyl having 1 to 30 carbon atoms, cycloalkyl having 3 to 30 carbon atoms, heteroalkyl having 1 to 30 carbon atoms, heterocycloalkyl having 2 to 30 carbon atoms, aryl having 6 to 30 carbon atoms, or heteroaryl having 2 to 30 carbon atoms, and at least two of $R^{401}$ to $R^{402}$ and $R^{501}$ to $R^{524}$ linked to one atom are optionally linked to form a ring;

Ys are each independently nitrogen, oxygen, sulfur or carbon;

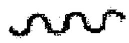

represents a linking site;

the additional substituents are present in numbers capable of bonding according to a stoichiometric ratio and are each independently selected from the group consisting of deuterium, halogen, cyano, -$NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, -B($R^{201}$)($R^{202}$), -C($R^{203}$)($R^{204}$)($R^{205}$), Si($R^{206}$)($R^{207}$)($R^{208}$), -Ge($R^{209}$)($R^{210}$)($R^{211}$), - N($R^{212}$)($R^{213}$), -P($R^{214}$)($R^{215}$), -PO($R^{216}$)($R^{217}$), -O($R^{218}$), -S($R^{219}$), -SO($R^{220}$), -$SO_2$($R^{221}$), Se($R^{222}$), -SeO($R^{223}$), -$SeO_2$($R^{224}$) and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms;

however, in Chemical Formula 10, L or R' " includes at least one atom having an unshared electron pair included in a wave function of HOMO or LUMO of the excited complex-forming moiety, or at least one of Ys is nitrogen, oxygen or sulfur.

**9.** The multifunctional compound of claim 1, wherein at least one R is represented by any one of structures of the following Chemical Formulae D-1 to D-38:

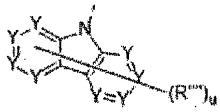

D-1

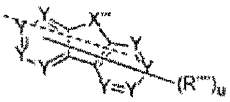

D-2

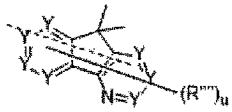

D-3

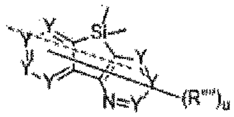

D-4

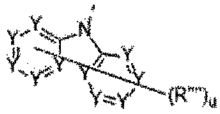

D-5

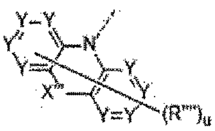

D-6

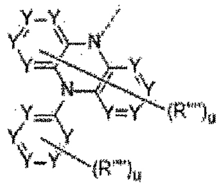

D-7

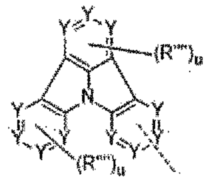

D-8

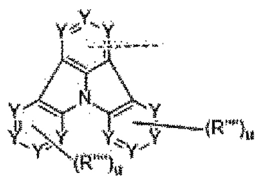

D-9

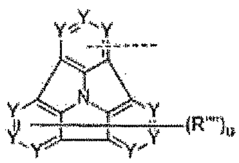

D-10

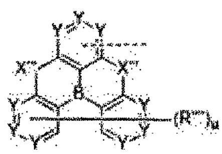

D-11

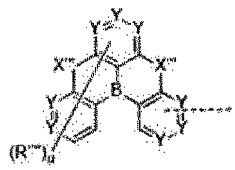

D-12

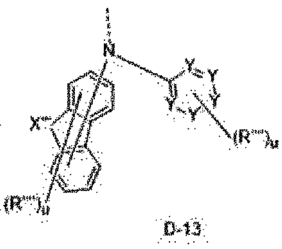

D-13

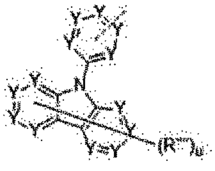

D-14

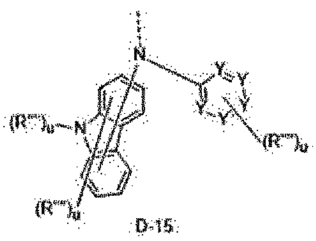

D-15

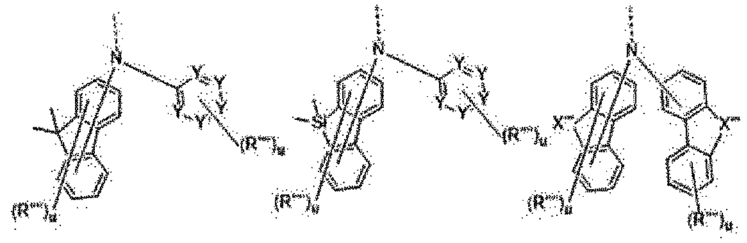

D-16 D-17 D-18

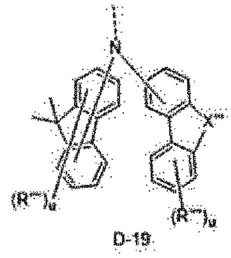

D-19

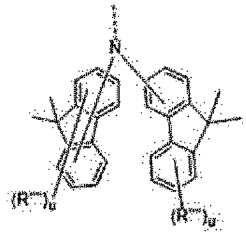

D-20

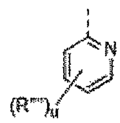

D-21

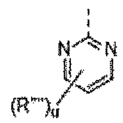

D-22

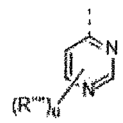

D-23

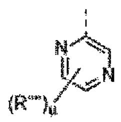

D-24

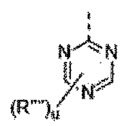

D-25

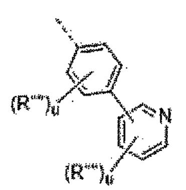

D-26

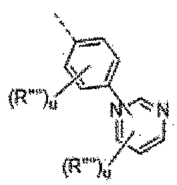

D-27

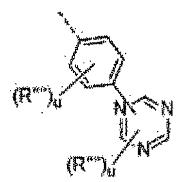

D-28

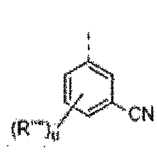

D-29

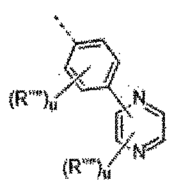

D-30

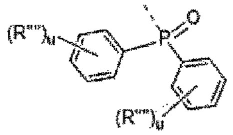

D-31

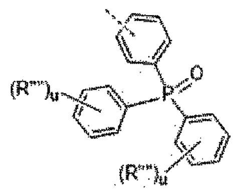

D-32

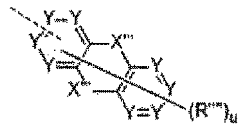

D-33

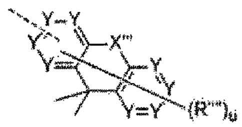

D-34

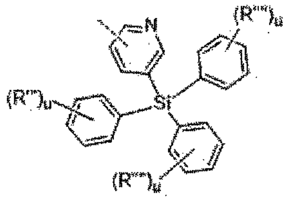

D-35

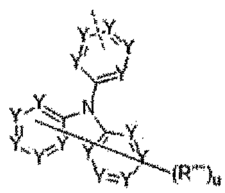

D-36

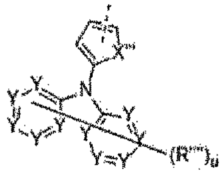

D-37

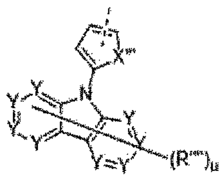

D-38

in Chemical Formulae D-1 to D-38,

Ys are each independently carbon or nitrogen;
X' "s are each independently oxygen, nitrogen, sulfur or selenium;
R""s are each independently selected from the group consisting of hydrogen, deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{601})(R^{602})$, $-C(R^{603})(R^{604})(R^{605})$, $-Si(R^{606})(R^{607})(R^{608})$, $-Ge(R^{609})(R^{610})(R^{611})$, $-N(R^{612})(R^{613})$, $-P(R^{614})(R^{615})$, $-PO(R^{616})(R^{617})$, $-O(R^{618})$, $-S(R^{619})$, $-SO(R^{620})$, $-SO_2(R^{621})$, $Se(R^{622})$, $-SeO(R^{623})$, $-SeO_2(R^{624})$ and combinations thereof, and $R^{601}$ to $R^{624}$ are each independently selected from hydrogen, deuterium, alkyl having 1 to 30 carbon atoms, cycloalkyl having 3 to 30 carbon atoms, heterocycloalkyl having 2 to 30 carbon atoms, aryl having 6 to 30 carbon atoms, heteroaryl having 2 to 30 carbon atoms and combinations thereof;
us are each independently an integer of 0 to 20; and
the dotted line represents a linking site.

**10.** The multifunctional compound of claim 1, comprising at least one deuterium.

**11.** The multifunctional compound of claim 1, wherein the multifunctional compound represented by Chemical Formula 1 is any one of the following compounds:

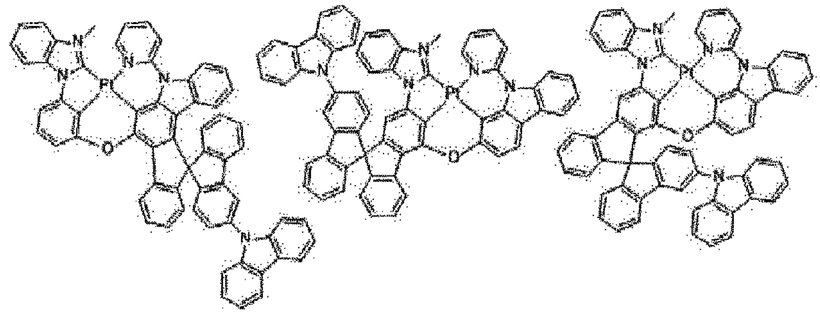

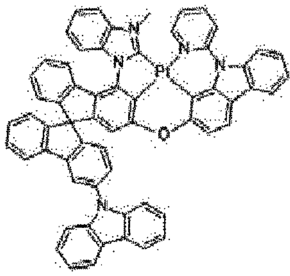

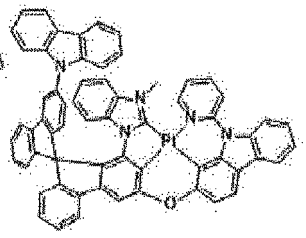

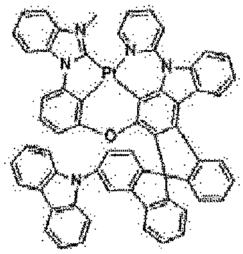

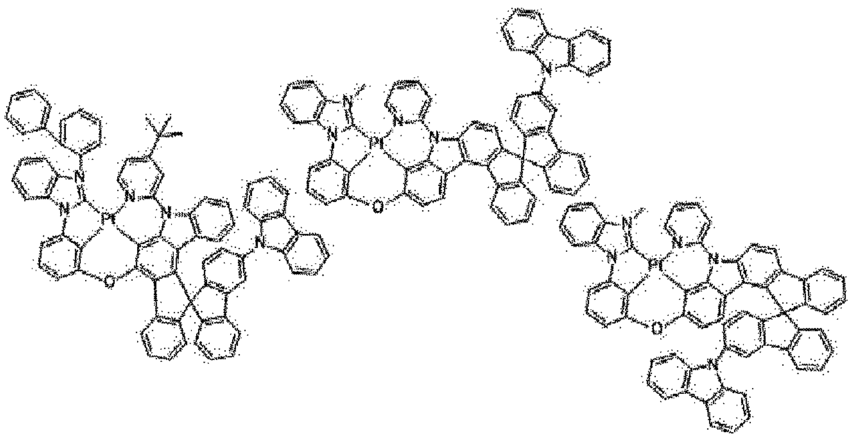

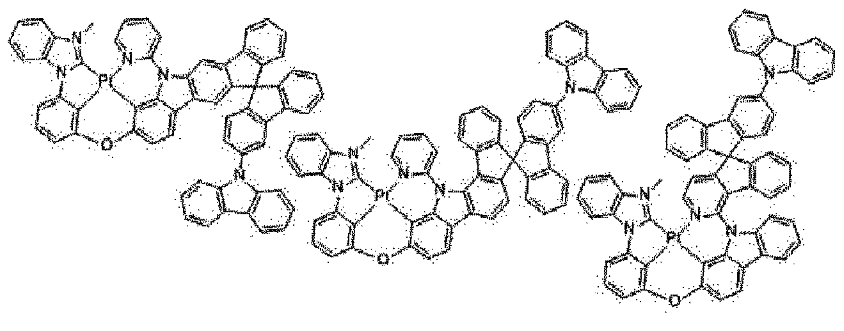

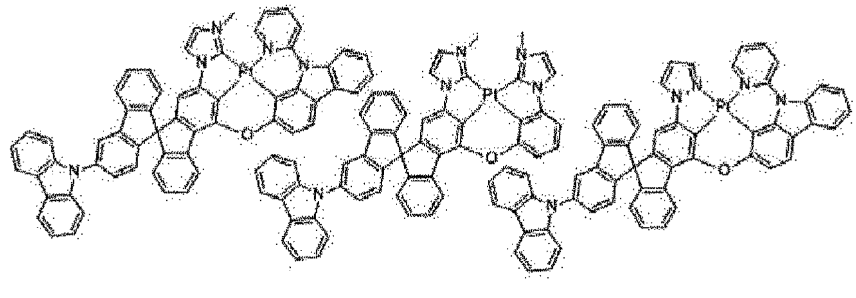

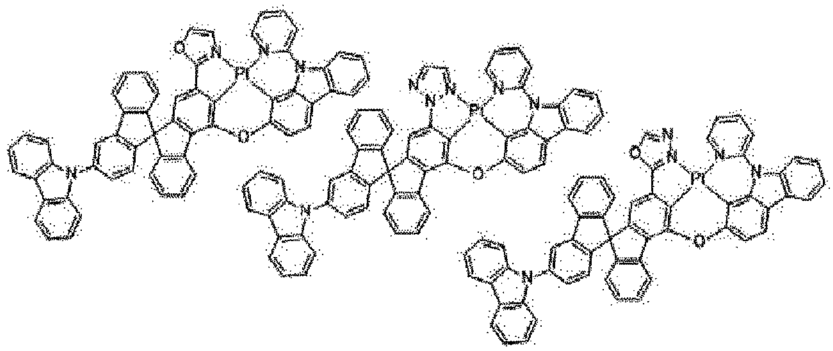

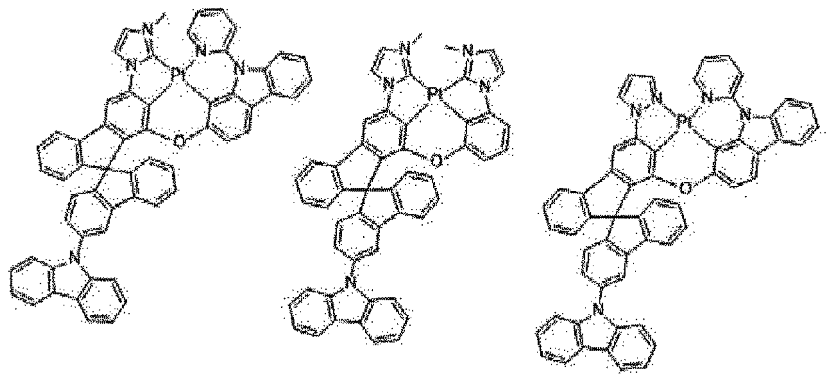

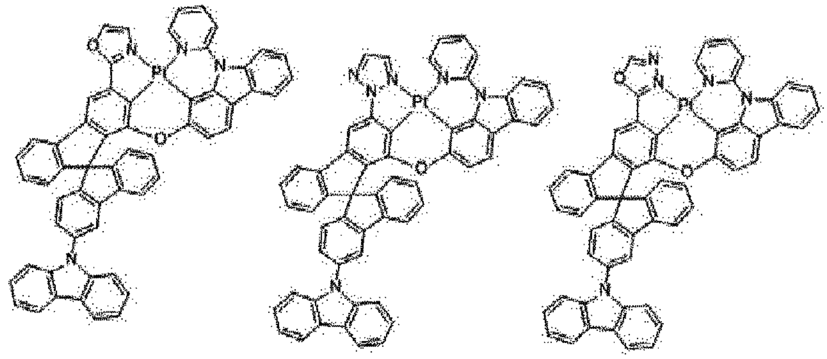

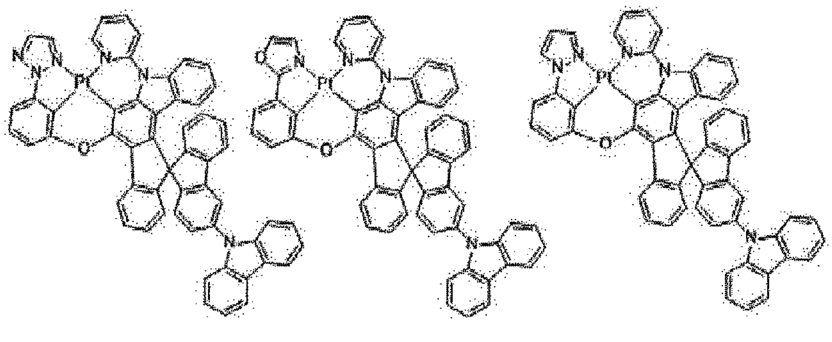

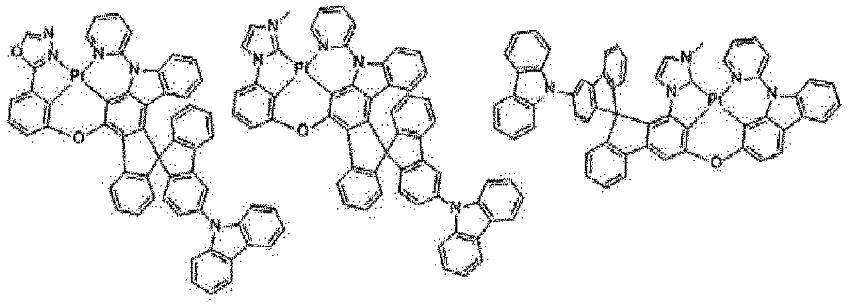

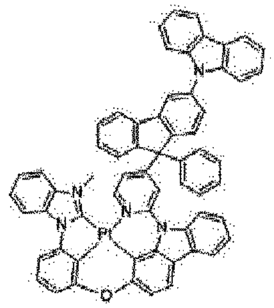

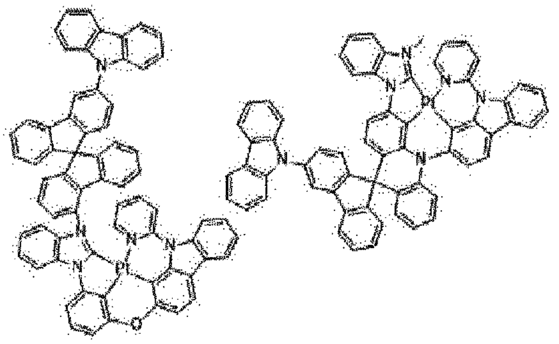

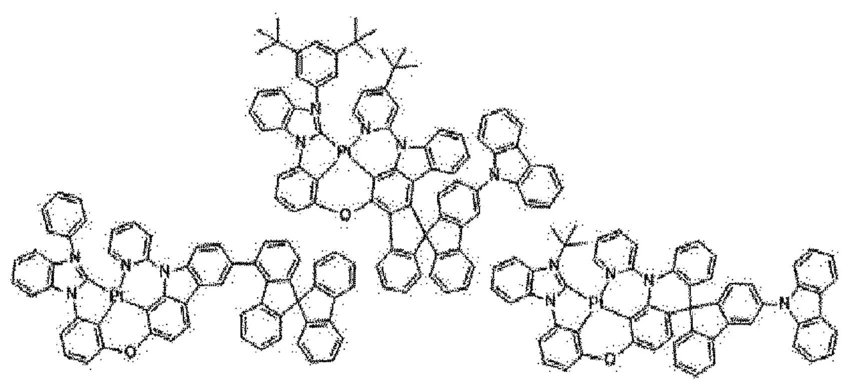

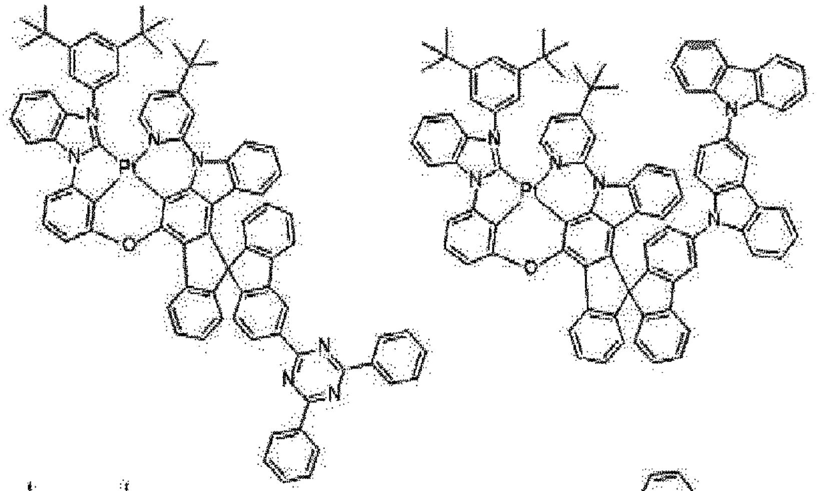

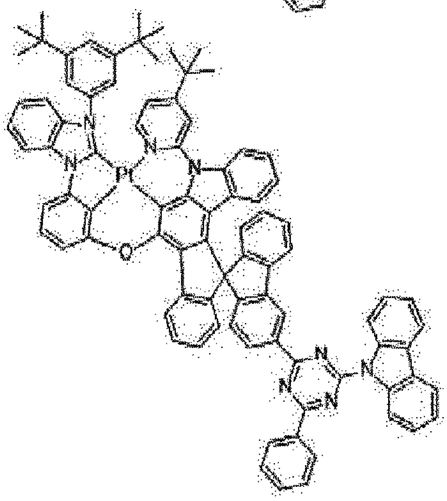

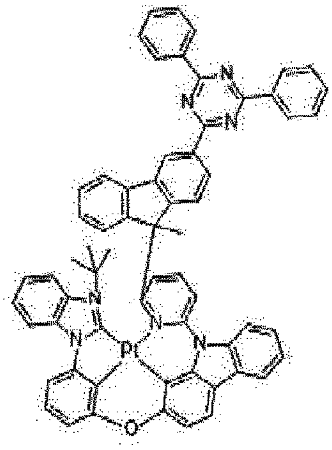

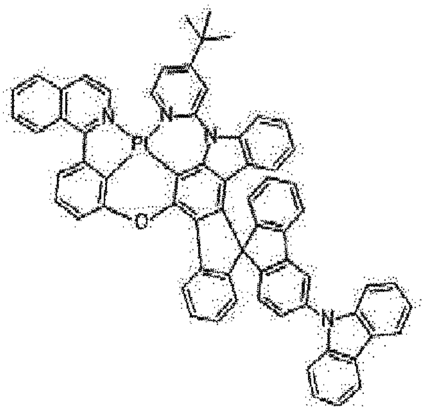

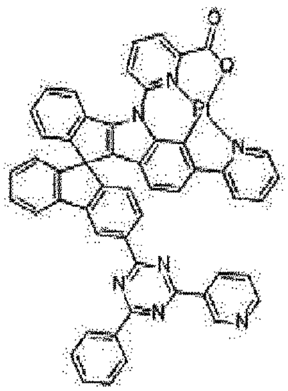

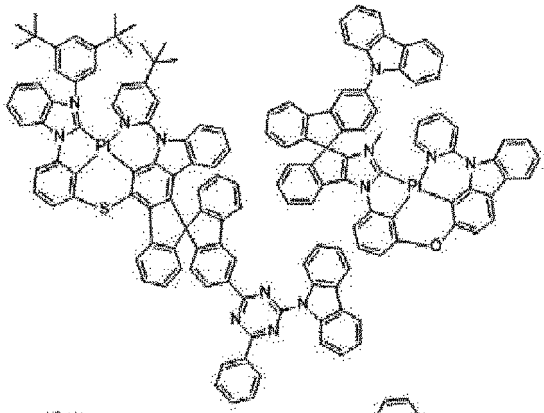
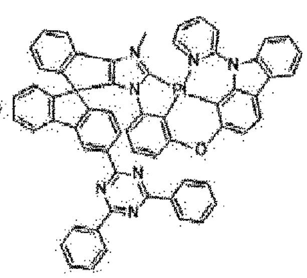

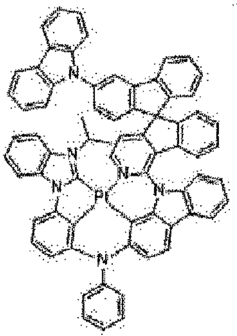
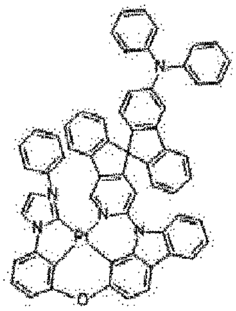
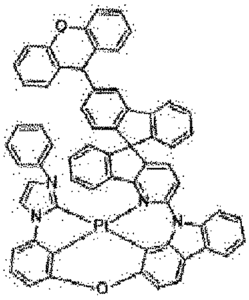

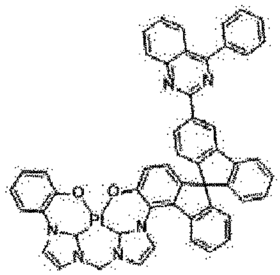
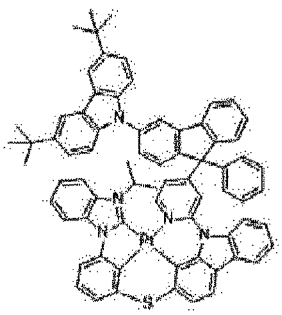

**12.** An organic light-emitting diode comprising:

a first electrode;
a second electrode;
a light-emitting layer disposed between the first electrode and the second electrode; and
further comprising or not comprising an organic layer adjacent to any one or both surfaces of the light-emitting layer,
wherein the light-emitting layer includes the multifunctional compound of any one of claims 1 to 11, and
the light-emitting layer or the adjacent organic layer includes an excited complex-forming compound.

**13.** The organic light-emitting diode of claim 12, wherein the multifunctional compound represented by Chemical Formula 1 is divided into an atom represented by X, a light-emitting moiety and an excited complex-forming moiety, the light-emitting moiety and the excited complex-forming moiety are linked through the atom represented by X, and the atom represented by X is X presented in Chemical Formula 1,

the light-emitting moiety includes A, a conjugated ring formed to include $Y^1$ to $Y^5$, and Q in Chemical Formula 1;
the excited complex-forming moiety includes a conjugated ring formed to include $Y^6$ to $Y^{10}$, a conjugated ring formed to include $Y^{11}$ to $Y^{15}$, and Z in Chemical Formula 1; and
the excited complex-forming moiety forms an excited complex with the excited complex-forming compound, and the light-emitting moiety emits light by receiving excited energy of the excited complex.

**14.** The organic light-emitting diode of claim 12, wherein the light-emitting layer includes at least two types of the multifunctional compound.

**15.** The organic light-emitting diode of claim 12, wherein the light-emitting layer further includes at least one selected from the group consisting of a host, an additional dopant and combinations thereof.

**16.** The organic light-emitting diode of claim 12, wherein the light-emitting layer further includes a phosphorescent material including Ir or Pt.

**17.** The organic light-emitting diode of claim 12, wherein the light-emitting layer further includes a delayed fluorescent material in which an energy difference between a singlet and a triplet is 0.3 eV or less.

**18.** The organic light-emitting diode of claim 12, which is a tandem-type organic light-emitting diode including a plurality of organic light-emitting units, wherein at least one of the plurality of organic light-emitting units includes the light-emitting layer.

【FIG. 1】

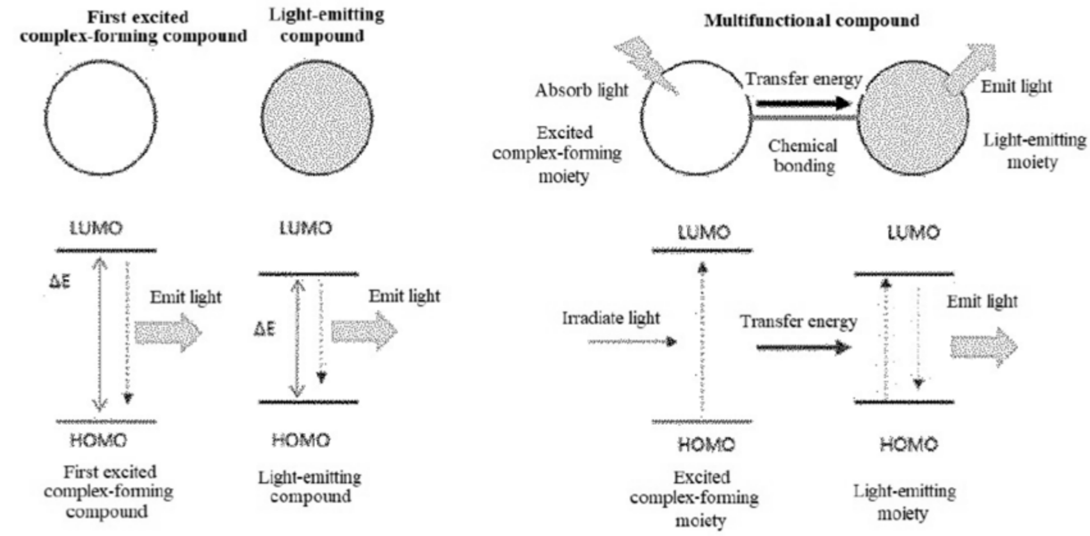
First excited
complex-forming compound
Light-emitting
compound
Multifunctional compound
Absorb light
Transfer energy
Emit light
Excited
complex-forming
moiety
Chemical
bonding
Light-emitting
moiety
LUMO
ΔE
Emit light
LUMO
ΔE
Emit light
HOMO
First excited
complex-forming
compound
HOMO
Light-emitting
compound
LUMO
LUMO
Irradiate light
Transfer energy
Emit light
HOMO
Excited
complex-forming
moiety
HOMO
Light-emitting
moiety

【FIG. 2】

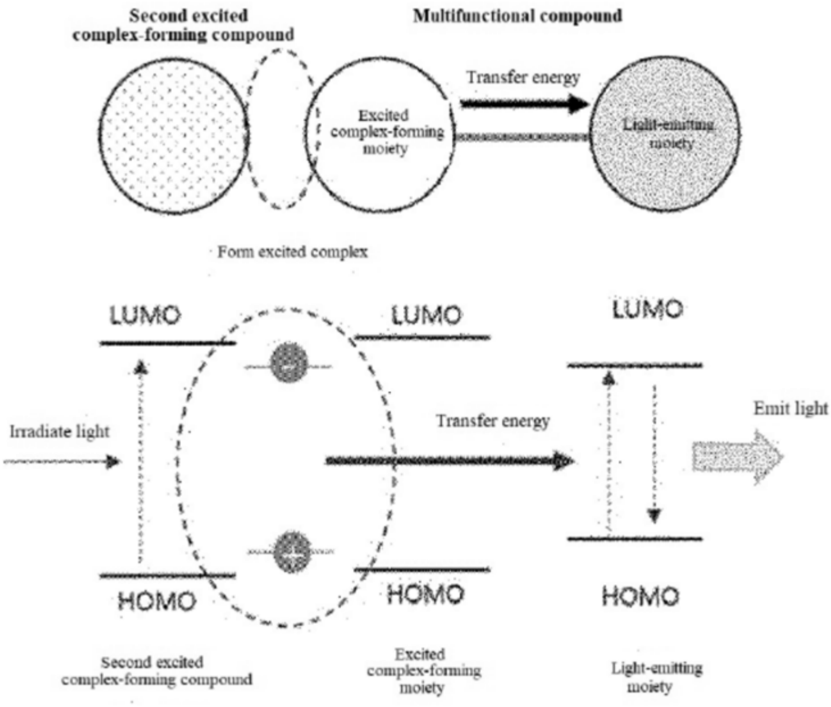
Second excited
complex-forming compound
Multifunctional compound
Transfer energy
Excited
complex-forming
moiety
Form excited complex
LUMO
LUMO
LUMO
Irradiate light
Transfer energy
Emit light
HOMO
HOMO
HOMO
Second excited
complex-forming compound
Excited
complex-forming
moiety
Light-emitting
moiety

【FIG. 3】

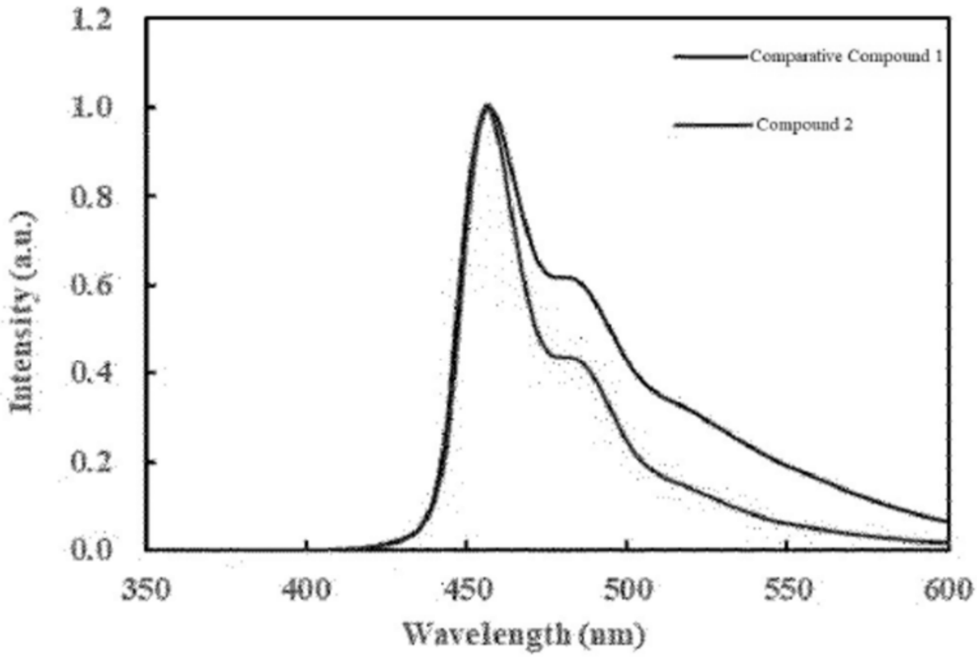
1.2
1.0
0.8
0.6
0.4
0.2
0.0
Intensity (a.u.)
350
400
450
500
550
600
Wavelength (nm)
Comparative Compound 1
Compound 2

## INTERNATIONAL SEARCH REPORT

International application No.
**PCT/KR2024/001207**

**A. CLASSIFICATION OF SUBJECT MATTER**

**C07F 15/00**(2006.01)i; **H10K 85/30**(2023.01)i; **H10K 50/12**(2023.01)i; **C09K 11/06**(2006.01)i; **H10K 101/20**(2023.01)i

According to International Patent Classification (IPC) or to both national classification and IPC

**B. FIELDS SEARCHED**

Minimum documentation searched (classification system followed by classification symbols)

C07F 15/00(2006.01); C09K 11/06(2006.01); H01L 51/00(2006.01); H10K 50/00(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus) & keywords: 유기발광다이오드(organic light emitting diode), 발광층 (light emitting layer), 들뜬 복합체 형성 모이어티(excited complex forming moiety), 발광 모이어티(light emitting moiety), 전이금속(transition metal)

**C. DOCUMENTS CONSIDERED TO BE RELEVANT**

| Category* | Citation of document, with indication, where appropriate, of the relevant passages | Relevant to claim No. |
|---|---|---|
| X | CN 114644660 A (ZHEJIANG HUASHENG PHOTOELECTRIC SCIENCE AND TECHNOLOGY LIMITED COMPANY) 21 June 2022 (2022-06-21)<br>See claims 1, 4 and 7-10; paragraph [0019]; and figure 1. | 1-18 |
| A | KR 10-2015-0043225 A (ARIZONA BOARD OF REGENTS ON BEHALF OF ARIZONA STATE UNIVERSITY et al.) 22 April 2015 (2015-04-22)<br>See entire document. | 1-18 |
| A | KR 10-2022-0134818 A (SAMSUNG DISPLAY CO., LTD.) 06 October 2022 (2022-10-06)<br>See entire document. | 1-18 |
| A | KR 10-2284600 B1 (LAPTO CO., LTD.) 02 August 2021 (2021-08-02)<br>See entire document. | 1-18 |
| A | KR 10-2022-0125864 A (SAMSUNG DISPLAY CO., LTD.) 15 September 2022 (2022-09-15)<br>See entire document. | 1-18 |

☐ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **17 May 2024** | **17 May 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2024/001207**

| Patent document cited in search report | Publication date (day/month/year) | Patent family member(s) | Publication date (day/month/year) |
|---|---|---|---|
| CN 114644660 A | 21 June 2022 | None | |
| KR 10-2015-0043225 A | 22 April 2015 | CN 104693243 A | 10 June 2015 |
| | | CN 112794870 A | 14 May 2021 |
| | | JP 2015-081257 A | 27 April 2015 |
| | | JP 2020-196736 A | 10 December 2020 |
| | | JP 2022-121471 A | 19 August 2022 |
| | | JP 6804823 B2 | 23 December 2020 |
| | | JP 7092830 B2 | 28 June 2022 |
| | | KR 10-2023-0053571 A | 21 April 2023 |
| | | KR 10-2521843 B1 | 13 April 2023 |
| | | US 10566553 B2 | 18 February 2020 |
| | | US 11189808 B2 | 30 November 2021 |
| | | US 2015-0105556 A1 | 16 April 2015 |
| | | US 2017-0012224 A1 | 12 January 2017 |
| | | US 2018-0301641 A1 | 18 October 2018 |
| | | US 2020-0152891 A1 | 14 May 2020 |
| | | US 2022-0069242 A1 | 03 March 2022 |
| | | US 9385329 B2 | 05 July 2016 |
| | | US 9947881 B2 | 17 April 2018 |
| KR 10-2022-0134818 A | 06 October 2022 | CN 115124577 A | 30 September 2022 |
| | | US 2022-0320447 A1 | 06 October 2022 |
| KR 10-2284600 B1 | 02 August 2021 | CN 116783207 A | 19 September 2023 |
| | | WO 2022-164086 A1 | 04 August 2022 |
| KR 10-2022-0125864 A | 15 September 2022 | CN 115010762 A | 06 September 2022 |
| | | US 2022-0310943 A1 | 29 September 2022 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6303238 B1


### Non-patent literature cited in the description


- **C. W. TANG**. *Appl. Phys. Lett*, 1987, vol. 51, 913
- *Nature*, 2012, vol. 492, 234-238
- **VALEUR, B** ; **BERBERAN-SANTOS, M.N**. Coulombic interaction. Wiley-VCH Verlag GmbH & co. KGaA, 2012